(19) Europäisches Patentamt
European Patent Office
Office européen des brevets

(11) EP 2 341 617 B1

(12) **FASCICULE DE BREVET EUROPEEN**

(45) Date de publication et mention de la délivrance du brevet:
**21.11.2018 Bulletin 2018/47**

(21) Numéro de dépôt: **10195864.3**

(22) Date de dépôt: **20.12.2010**

(51) Int Cl.:
*H03H 3/04* (2006.01) *H03H 9/02* (2006.01)
*H03H 9/58* (2006.01) *H03H 9/17* (2006.01)

(54) **Résonateur acoustique comprenant un électret, et procédé de fabrication de ce résonateur, application aux filtres commutables à résonateurs couplés**

Akustischer Resonator, der ein Elektret umfasst, sowie Herstellungsverfahren dieses Resonators und Anwendung auf gekoppelte Resonatoren bei umschaltbaren Filtern

Acoustic resonator including an electret, and method for manufacturing said resonator, application to coupled-resonator switchable filters

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.12.2009 FR 0959510**

(43) Date de publication de la demande:
**06.07.2011 Bulletin 2011/27**

(73) Titulaire: **Commissariat à l'Énergie Atomique et aux Énergies Alternatives**
**75015 Paris (FR)**

(72) Inventeurs:
- **Defay, Emmanuel**
  **38340 Voreppe (FR)**
- **Boisseau, Sébastien**
  **38100 Grenoble (FR)**
- **Despesse, Ghislain**
  **38120 Saint-Egreve (FR)**
- **Ivira, Brice**
  **18150 La Guerche sur l'Aubois (FR)**
- **Reinhardt, Alexandre**
  **38000 Grenoble (FR)**

(74) Mandataire: **Ilgart, Jean-Christophe et al**
**BREVALEX**
**95, rue d'Amsterdam**
**75378 Paris Cedex 8 (FR)**

(56) Documents cités:
**DE-B- 1 245 441**
**US-A- 2 486 560**
**US-A- 3 118 022**
**US-A- 4 057 660**
**US-A1- 2007 063 793**

- **WEI PANG ET AL: "Electrical Frequency Tuning of Film Bulk Acoustic Resonator", JOURNAL OF MICROELECTROMECHANICAL SYSTEMS, IEEE, vol. 16, no. 6, 1 décembre 2007 (2007-12-01), pages 1303-1313, XP011197843,**
- **LEONOV ET AL: "Stabilization of positive charge in SiO2/Si3N4 electrets", IEEE TRANSACTIONS ON DIELECTRICS AND ELECTRICAL INSULATION, IEEE SERVICE CENTER, PISCATAWAY, NJ, US, vol. 13, no. 5, 1 October 2006 (2006-10-01), pages 1049-1056, XP011142340, ISSN: 1070-9878**
- **GUNTHER ET AL: "SiO2 electrets for electric-field generation in sensors and actuators", SENSORS AND ACTUATORS A, ELSEVIER SEQUOIA S.A., LAUSANNE, CH, vol. 32, no. 1-3, 1 April 1992 (1992-04-01), pages 357-360, XP026577000, ISSN: 0924-4247, DOI: 10.1016/0924-4247(92)80012-R [retrieved on 1992-04-01]**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

**Description**

**DOMAINE TECHNIQUE**

La présente invention concerne un résonateur acoustique et un procédé de fabrication de ce résonateur.

Elle s'applique notamment au domaine des télécommunications, et plus particulièrement à la téléphonie mobile.

**ÉTAT DE LA TECHNIQUE ANTÉRIEURE**

De nombreux résonateurs acoustiques sont nécessaires dans le domaine de la téléphonie mobile, notamment pour les dispositifs de filtrage et de référence de temps. Dans ces dispositifs, on utilise actuellement des résonateurs acoustiques de type SAW (pour *Surface Acoustic Wave*) ou de type BAW (pour *Bulk Acoustic Wave*) qui emploient des matériaux piézoélectriques tels que $LiNbO_3$, $LiTaO_3$ et AlN.

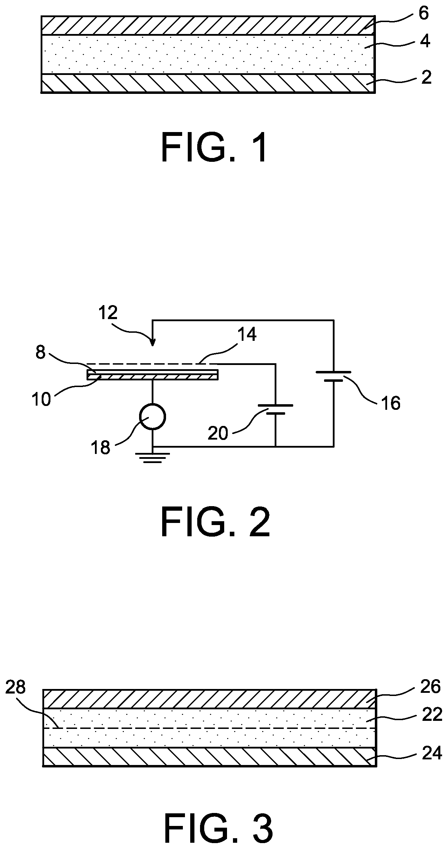

Comme le montre schématiquement la figure 1, un résonateur de type BAW est typiquement constitué de trois couches : une électrode inférieure 2, une couche piézoélectrique 4 et une électrode supérieure 6. La fréquence de résonance d'un tel résonateur est déterminée au premier ordre par l'épaisseur de la couche piézoélectrique 4.

Selon les normes des télécommunications, la précision requise pour la détermination de la fréquence de résonance est de l'ordre de 0,1%. Cela signifie que la précision sur l'épaisseur de la couche piézoélectrique doit atteindre également cette valeur.

Il convient toutefois de noter que l'épaisseur des électrodes intervient également dans la valeur de la fréquence de résonance et qu'il est donc indispensable de bien maîtriser aussi leur épaisseur.

Or, les techniques de dépôt (en particulier la pulvérisation cathodique), qui sont classiquement utilisées pour former les couches de matériaux piézoélectriques (notamment l'AlN qui est de loin le matériau le plus employé pour les résonateurs de type BAW) ou les électrodes, permettent d'atteindre au mieux une précision de 1% sur des plaques (en anglais, *wafers*) de 200 mm de diamètre.

Ainsi, pour atteindre un rendement important sur de telles plaques, il est indispensable de prévoir une étape d'ajustement (en anglais, *trimming*) de la fréquence de résonance. Au cours de cette étape, on effectue la gravure localisée d'une charge (en anglais, *load*) que l'on a préalablement déposée sur chaque résonateur ; il s'agit typiquement d'une couche de $SiO_2$ ou de SiN ou bien de l'électrode supérieure elle-même.

Une première mesure de la fréquence de résonance est réalisée après le dépôt de cette charge.

Grâce à un équipement spécifique, on grave ensuite localement une épaisseur définie de la couche qui charge le résonateur afin de réajuster la fréquence de résonance sur la fréquence désirée.

Cette étape d'ajustement permet d'augmenter considérablement le rendement de fabrication des plaques.

Cependant, elle nécessite un équipement spécifique de gravure localisée, qui est coûteux et très délicat à maîtriser et dont la maintenance est difficile.

Pour changer la fréquence de résonance d'un résonateur de type BAW, il est également possible d'appliquer à ce dernier une tension continue, en plus du signal de radiofréquence qui est utilisé pour son fonctionnement.

En effet, on a montré que les matériaux piézoélectriques, en particulier l'AlN, présentaient une dérive de leur fréquence de résonance avec une telle tension continue.

Le phénomène physique associé à cette dérive est une variation de la raideur de l'AlN en fonction de la tension continue, variation qui entraîne elle-même une variation de la vitesse acoustique et donc de la fréquence de résonance.

A ce sujet, on peut se reporter à la thèse de Roman Lanz, Piezoelectric Thin Films for Bulk Acoustic Wave Resonator Applications : From Processing to Microwave Filters, thèse présentée à l'Ecole Polytechnique Fédérale de Lausanne (2004).

Plus précisément, on peut se reporter à la page 64 de ce document où la variation mentionnée plus haut est représentée.

La valeur typique de la variation observée est égale à 72 ppm/V pour une couche d'AlN de 380 nm d'épaisseur dont la fréquence d'antirésonance est de l'ordre de 8 GHz.

Cela signifie que l'application d'une tension de +70V à cette couche d'AlN induit une variation de la fréquence d'antirésonance de +0,5%. En outre, l'application d'une tension de -70V induit une variation de cette fréquence de -0,5%.

Par ailleurs, l'AlN possède un champ de claquage de l'ordre de 5 MV/cm. Par conséquent, pour une épaisseur de 380 nm, sa tension de claquage est de l'ordre de 190 V. Ainsi, l'application de +70 V ou -70 V à 380 nm d'AlN ne provoque pas le claquage du matériau et induit une variation de 1% (ou de +/-0,5%) de la fréquence d'antirésonance.

Il convient de noter que les variations des fréquences de résonance et d'antirésonance sont quasiment identiques dans l'AlN lorsqu'une tension continue est appliquée.

Ainsi, l'application d'une tension continue est une solution pour ajuster les fréquences caractéristiques d'un résonateur, pour les applications de ce dernier aux télécommunications, en vue de compenser les variations d'épaisseur qui sont de l'ordre de 1%.

Cependant, cette solution n'est pas applicable dans le cas d'un téléphone portable. En effet, la tension de la batterie de ce dernier est seulement de l'ordre de quelques volts (typiquement 3 V) alors que l'on aurait besoin d'une centaine de volts comme on l'a vu plus haut.

US 2007/0063793 décrit un résonateur acoustique massif en polymère. US 2486560 décrit un transducteur et son procédé de fabrication. Leonov et al., IEEE Transactions on dielectrics and electrical insulation, vol. 13, n°5, 1 octobre 2006, pp. 1049-1056, décrit la stabilisation de charges positives dans des électrets $SiO_2/Si_3N_4$. Gunther et al., Sensors and actuators A., Elsevier Sequoia S.A., vol. 32, n°1-3, 1 avril 1992, pp. 357-360, décrit des électrets de $SiO_2$ pour la génération de champ électrique dans des capteurs et des actionneurs. Wei Pang et al., Journal of microelectromechanical systems, IEEE, vol. 16, n°6, 1 décembre 2007, pp. 1303-1313, décrit l'accord de fréquence électrique d'un résonateur acoustique massif en couche. US 4057660 décrit un procédé de fabrication d'un élément élastique en couche thermoplastique. DE 1245441 décrit l'utilisation d'un électret pour la polarisation permanente d'un système oscillant. US 3118022 décrit un transducteur électroacoustique.

## EXPOSÉ DE L'INVENTION

La présente invention a pour but de remédier aux inconvénients des solutions connues, mentionnées plus haut.

Selon l'invention, pour décaler la fréquence de résonance d'un résonateur acoustique, comprenant une couche de matériau piézoélectrique, on adjoint un électret à cette dernière. Cet électret applique un champ électrique permanent et constant à la couche.

Ce champ électrique décale la fréquence de résonance du résonateur. Plus précisément, l'intensité de ce champ électrique est déterminée pour décaler la fréquence de résonance d'une valeur souhaitée.

On rappelle qu'un électret permet d'appliquer un champ électrique continu sans alimentation électrique, de même qu'un aimant applique un champ magnétique permanent sans alimentation extérieure permanente.

Un tel électret est obtenu en chargeant une couche mince d'un matériau diélectrique, tel que la silice ou le nitrure de silicium, en y implantant des charges électriques (électrons ou trous) par une technique telle que la décharge Corona, l'implantation électronique ou l'implantation ionique.

L'intensité du champ électrique résultant de cette implantation est fonction de la quantité des charges électriques implantées.

La présente invention a notamment pour objet un résonateur acoustique, comprenant :

- au moins une couche piézoélectrique,
- des première et deuxième électrodes de part et d'autre de la couche piézoélectrique, et
- au moins une couche d'électret entre les première et deuxième électrodes,

caractérisé en ce que la couche d'électret est prévue pour appliquer un champ électrique permanent à la couche piézoélectrique, dont l'intensité est telle que ce champ électrique décale la fréquence de résonance du résonateur d'une valeur souhaitée et en ce que la couche d'électret est faite d'un matériau minéral.

Selon un mode de réalisation particulier du résonateur acoustique, objet de l'invention, la ou les couches piézoélectriques présentant respectivement des propriétés électromécaniques, ladite couche d'électret comporte des charges électriques permanentes, permettant de modifier lesdites propriétés électromécaniques.

On entend, par propriétés électromécaniques d'une couche, notamment le couplage électromécanique de ladite couche, sa constante diélectrique et sa raideur.

La couche d' électret peut être en matériau piézoélectrique. Dans ce cas, la couche d'électret est confondue avec la couche piézoélectrique ou est formée par une couche distincte.

L'épaisseur de la couche d' électret peut être choisie de quelques nanomètres à quelques dizaines de micromètres ; de préférence, elle est inférieure ou égale à environ 1 $\mu$m.

Le résonateur acoustique, objet de l'invention, peut comporter en outre un substrat sur une face duquel est disposée l'une des électrodes.

On précise que, quelle que soit l'épaisseur de l'empilement formé par la couche piézoélectrique et la couche d' électret, ce résonateur peut comporter un substrat. De plus, l'électrode mentionnée ci-dessus peut être disposée sur le substrat soit directement, soit par l'intermédiaire d'une couche intermédiaire.

La couche piézoélectrique peut contenir des charges électriques pour constituer elle-même la couche d'électret, de sorte que la couche piézoélectrique et la couche d'électret constituent alors une seule et même couche.

La couche d'électret peut être distincte de la ou les couches piézoélectriques.

Dans ce cas, selon un premier mode de réalisation particulier, la couche d'électret est comprise entre la couche piézoélectrique et l'une des première et deuxième électrodes.

Dans le même cas, selon un deuxième mode de réalisation particulier, le résonateur acoustique comprend des première et deuxième couches piézoélectriques et la couche d' électret est comprise entre les première et deuxième couches piézoélectriques.

Selon un premier mode de réalisation particulier de l'invention, le substrat est pourvu d'une cavité, ou trou, qui débouche au moins sur une face du substrat, et l'une des première et deuxième électrodes repose sur cette face du substrat, au-dessus de la cavité.

Ce trou peut être traversant ou non.

Selon un deuxième mode de réalisation particulier de l'invention, le résonateur acoustique comprend en outre un réseau de Bragg acoustique, disposé entre le substrat et l'une des première et deuxième électrodes.

Dans l'invention, la couche d' électret peut être cristalline ou, au contraire, amorphe.

La présente invention concerne aussi un filtre commutable à résonateurs couplés, comprenant des résonateurs acoustiques qui sont couplés acoustiquement les uns aux autres, et dans lequel l'un au moins des résonateurs acoustiques est le résonateur acoustique, objet de l'invention.

La présente invention concerne en outre un procédé de fabrication d'un résonateur acoustique, comprenant :

- la formation d'au moins une couche piézoélectrique,
- la formation de première et deuxième électrodes de part et d'autre de la couche piézoélectrique, et
- la formation d'au moins une couche d'électret faite d'un matériau minéral entre les première et deuxième électrodes, pour appliquer un champ électrique continu et permanent à la couche piézoélectrique,

dans lequel l'intensité de ce champ électrique est déterminée pour décaler la fréquence de résonance du résonateur d'une valeur souhaitée.

Selon un premier mode de réalisation particulier, le procédé objet de l'invention comprend, à partir d'un substrat pourvu de la première électrode et d'une couche sacrificielle au niveau d'une face du substrat, la première électrode reposant sur cette face du substrat, au-dessus de la couche sacrificielle :

- la formation d'une structure sur la première électrode, la structure étant choisie parmi :
  - une couche apte à constituer à la fois la couche piézoélectrique et la couche d'électret, de sorte que la couche piézoélectrique et la couche d'électret constituent alors une seule et même couche,
  - un ensemble comprenant la couche piézoélectrique et une couche apte à constituer la couche d'électret, et
  - un ensemble comprenant des première et deuxième couches piézoélectriques et une couche apte à constituer la couche d' électret, entre les première et deuxième couches piézoélectriques,
- la formation de la deuxième électrode,
- le chargement électrique permanent de la couche apte à constituer la couche d'électret, et
- l'élimination de tout ou partie de la couche sacrificielle.

Selon un deuxième mode de réalisation particulier, le procédé objet de l'invention comprend :

- la formation d'un réseau de Bragg acoustique (en anglais, *acoustic Bragg grating*) sur un substrat,
- la formation de la première électrode sur le réseau de Bragg acoustique,
- la formation d'une structure sur la première électrode, la structure étant choisie parmi :
  - une couche apte à constituer à la fois la couche piézoélectrique et la couche d'électret, de sorte que la couche piézoélectrique et la couche d'électret constituent alors une seule et même couche,
  - un ensemble comprenant la couche piézoélectrique et une couche apte à constituer la couche d'électret, et
  - un ensemble comprenant des première et deuxième couches piézoélectriques et une couche apte à constituer la couche d'électret, entre les première et deuxième couches piézoélectriques,
- la formation de la deuxième électrode, et
- le chargement électrique permanent de la couche apte à constituer la couche d'électret.

On précise que dans ce procédé, y compris dans ses deux modes de réalisation précédents, l'ordre des étapes peut être modifié.

Le chargement électrique permanent de la couche apte à constituer la couche d'électret peut être effectué par une méthode choisie parmi l'implantation ionique et/ou l'implantation électronique.

En variante, le chargement électrique permanent de la couche apte à constituer la couche d' électret est effectué par une méthode choisie parmi l'implantation ionique et/ou l'implantation électronique et/ou la décharge Corona et/ou la méthode de l'électrode humide ; le chargement électrique permanent est alors effectué avant la formation de la deuxième électrode.

Selon un mode de réalisation particulier du procédé objet de l'invention, pour une ou des couches piézoélectriques formant un empilement présentant une fréquence de résonance, les charges électriques permanentes, introduites dans la couche apte à constituer la couche d'électret, sont telles qu'elles permettent d'obtenir un décalage déterminé ou choisi, de la fréquence de résonance de l'empilement, ce qui permet d'ajuster la fréquence du résonateur.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

- la figure 1 est une vue schématique d'un empilement typique pour un résonateur à onde de volume (de type BAW) et a déjà été décrite,
- la figure 2 est une vue schématique d'un dispositif de décharge Corona (triode), de type pointe-grille,
- la figure 3 est une vue schématique d'une structure qui est utilisable dans l'invention et dans laquelle une couche piézoélectrique sert également de couche d'électret,
- les figures 4A et 4B sont des vues schématiques d'autres structures qui sont utilisables dans l'invention et dans lesquelles la couche piézoélectrique et l'électret sont dissociés,
- la figure 5 est une vue schématique d'une autre structure qui est utilisable dans l'invention et dans laquelle l'électret est compris entre deux couches piézoélectriques,
- les figures 6A à 6L illustrent schématiquement un premier mode de réalisation particulier du procédé, objet de l'invention,
- les figures 7A à 7H illustrent schématiquement un deuxième mode de réalisation particulier du procédé, objet de l'invention,
- les figures 8A et 8B illustrent schématiquement un troisième mode de réalisation particulier du procédé, objet de l'invention,
- la figure 9 illustre schématiquement un quatrième mode réalisation particulier du procédé, objet de l'invention,
- les figures 10A et 10B illustrent schématiquement un cinquième mode de réalisation particulier du procédé, objet de l'invention,
- la figure 11 est une vue en coupe schématique d'un mode de réalisation particulier du filtre commutable à résonateurs couplés, objet de l'invention,
- les figures 12, 13 et 14 illustrent schématiquement le principe de la méthode de l'électrode humide, qui est utilisable dans l'invention,
- les figures 15A et 15B illustrent schématiquement deux topologies à couplage électrique, exploitées dans les filtres BAW : la topologie en échelle (en anglais, *ladder*) (figure 15A) et la topologie en treillis (en anglais, *lattice*) (figure 15B),
- les figures 16A et 16B illustrent schématiquement le principe de fonctionnement d'un filtre en échelle, et
- les figures 17A et 17B illustrent schématiquement deux topologies à couplage acoustique, exploitées dans les filtres BAW.

## EXPOSÉ DÉTAILLÉ DE MODES DE RÉALISATION PARTICULIERS

On mentionne dans la suite la mise en oeuvre d'une décharge Corona.

A ce sujet, on se reportera par exemple à l'article de J.A. Giacometti et al., Corona Charging of Polymers, IEEE Transactions on Electrical Insulation, vol. 27, n°5, octobre 1992.

La figure 2 illustre schématiquement un dispositif de décharge Corona de type triode (électrode-pointe-grille).

Pour mettre en oeuvre cette technique, l'échantillon 8, dans lequel on veut implanter des charges, repose sur une électrode 10 qui est mise à la masse.

Une électrode 12 en forme de pointe est placée au-dessus de l'échantillon 8. Une grille 14 est disposée entre l'électrode 10 et l'échantillon 8.

La décharge est obtenue en portant l'électrode 10 à un potentiel positif, au moyen d'une source de tension appropriée 16. Comme on le voit sur la figure 2, le courant de la décharge est mesuré par un ampèremètre 18 et commandé en réglant le potentiel de la grille 14 au moyen d'une source de tension appropriée 20.

On reviendra sur la décharge Corona à la fin de la présente description.

Une autre technique utilisée dans la présente invention est l'implantation électronique. A ce sujet, on peut se reporter par exemple au brevet EP 0 608 162.

Les électrets sont utilisés dans certains microsystèmes, notamment pour la fabrication de microphones (voir par exemple le brevet US 6 928 178) et pour la fabrication de certains systèmes de récupération d'énergie (voir par exemple l'article de Fabio Peano et al., Design and optimisation of a MEMS electret-based capacitive energy scavenger, J. of Electromechanical systems, vol.14 (3), 2005).

Dans l'état de la technique, l'électret est utilisé pour ses propriétés de piézoélectricité induite.

Dans le cadre de la présente invention, on l'utilise uniquement pour son champ électrique qui reste constant dans le temps et qui existe en l'absence de toute tension continue, appliquée de manière perpétuelle.

La figure 3 est une vue en coupe schématique d'une première structure que l'on peut utiliser dans un résonateur acoustique conforme à l'invention. Cette structure comprend une couche résonante 22 entre deux électrodes 24 et 26 qui sont par exemple toutes deux en molybdène.

Dans cette structure, la couche résonante 22 est faite d'un matériau piézoélectrique, par exemple AlN, ZnO ou $Pb(Zr,Ti)O_3$.

En outre, elle sert elle-même de couche d'électret et, à cet effet, des charges électriques 28 y sont implantées.

Un champ électrique est ainsi appliqué en permanence à la couche résonante 22. Comme on l'a vu plus haut, l'intensité de ce champ électrique est déterminée pour décaler la fréquence de résonance du résonateur d'une valeur souhaitée.

En variante, la couche résonante est faite d'un matériau électrostrictif (c'est-à-dire d'un matériau diélectrique qui n'est pas piézoélectrique), par exemple $(Ba,Sr)TiO_3$, $SrTiO_3$, $Pb(Mg,Nb)\ TiO_3$, ou $(Pb,La)\ (Zr,Ti)O_3$ ; et elle sert encore de couche d'électret, les charges électriques y étant implantées à cet effet.

Pour utiliser le résonateur acoustique qui comporte la structure représentée sur la figure 3, on applique un signal radiofréquence à l'une des deux électrodes tandis que l'autre électrode est mise à la masse.

Il en est de même pour les résonateurs acoustiques décrits par la suite.

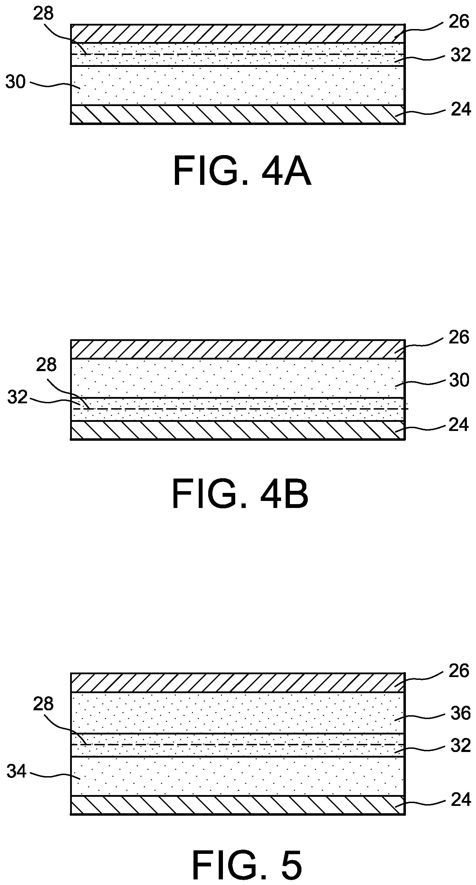

La figure 4A est une vue en coupe schématique d'une deuxième structure que l'on peut utiliser dans un résonateur acoustique conforme à l'invention.

Cette structure comprend deux couches distinctes l'une de l'autre entre l'électrode 24 (électrode inférieure) et l'électrode 26 (électrode supérieure), à savoir une couche résonante 30 et une couche d'électret 32.

Cette dernière est comprise entre la couche résonante 30 et l'électrode supérieure 26.

Dans la variante représentée sur la figure 4B, elle est au contraire comprise entre la couche résonante 30 et l'électrode inférieure 24.

Dans la structure (figure 4A ou 4B), la couche 30 est faite d'un matériau piézoélectrique, par exemple AlN, ZnO ou $Pb(Zr,Ti)O_3$.

On peut aussi utiliser un matériau électrostrictif, par exemple $(Ba,Sr)TiO_3$, $SrTiO_3$, $Pb(Mg,Nb)TiO_3$ ou $(Pb,La)$ $(Zr,Ti)O_3$.

La couche d'électret peut être faite, quant à elle, de tout diélectrique susceptible de conserver les charges 28 qui y ont été implantées, par exemple $SiO_2$, SiN, ou $Al_2O_3$.

La figure 5 est une vue en coupe schématique d'une troisième structure que l'on peut utiliser dans un résonateur acoustique, conforme à l'invention.

Il s'agit d'une variante des figures 4A et 4B, dans laquelle la couche d'électret 32, pourvue des charges électriques 28, est comprise entre deux couches résonantes 34 et 36.

Chacune de ces dernières peut encore être faite d'un matériau piézoélectrique ou d'un matériau électrostrictif.

L'ensemble des couches 32, 34 et 36 est encore compris entre les électrodes 24 et 26 comme on le voit sur la figure.

Le fait de placer la couche d'électret 32 entre les couches résonantes 34 et 36 permet d'augmenter l'effet électret, c'est à dire d'augmenter l'intensité du champ électrique qui est appliqué au matériau piézoélectrique ou électrostrictif par l'électret.

Dans ce qui suit, on donne divers exemples du procédé de fabrication d'un résonateur acoustique conforme à l'invention.

Pour obtenir l'électret, il y a deux possibilités :

- implanter les charges électriques dans la couche piézoélectrique (le cas de la couche électrostrictive sera considéré par la suite),
- implanter ces charges dans une couche supplémentaire, par exemple une couche de $SiO_2$, qui peut également permettre une compensation thermique.

Le premier exemple concerne la fabrication d'un résonateur acoustique de type FBAR (pour *Film Bulk Acoustic Resonator*) dont le matériau piézoélectrique est le nitrure d'aluminium (AlN).

Les diverses étapes du procédé de fabrication sont détaillées ci-après.

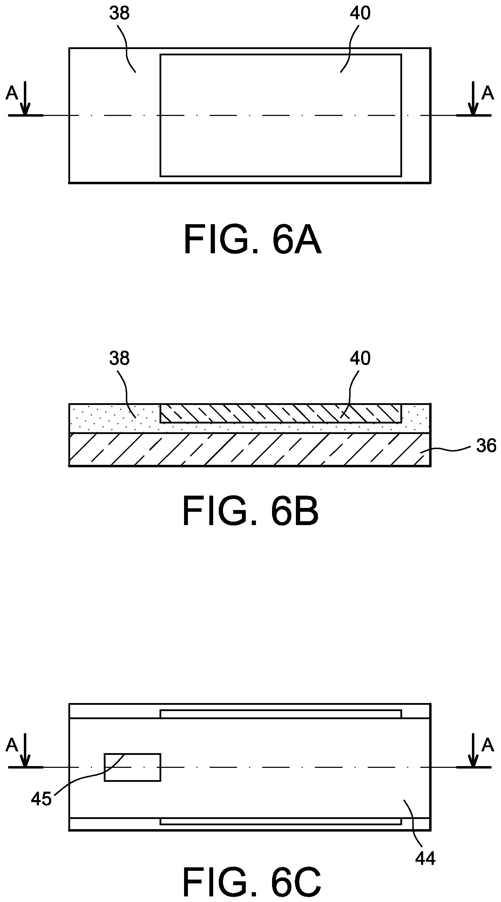

- On part d'un substrat 36 de silicium, de 200 mm de diamètre et d'épaisseur typique 700 $\mu$m (voir la figure 6A qui est une vue de dessus du résonateur en cours de fabrication, et la figure 6B qui est la coupe AA de la figure 6A).

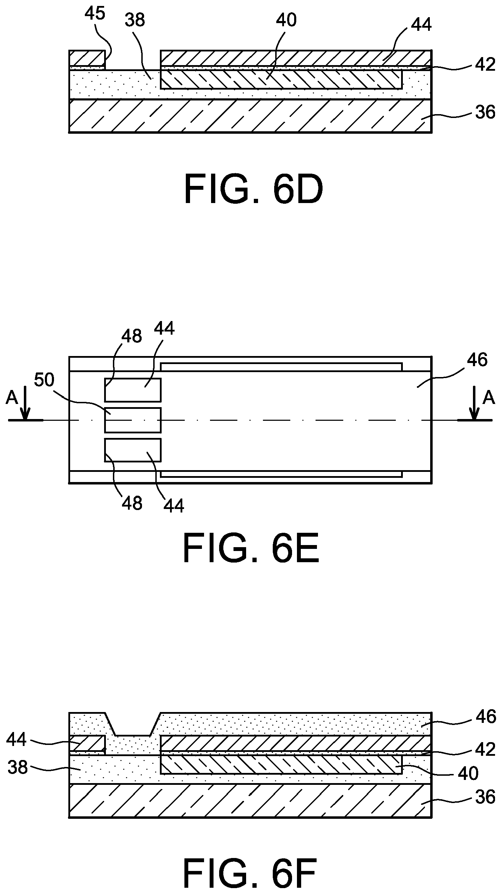

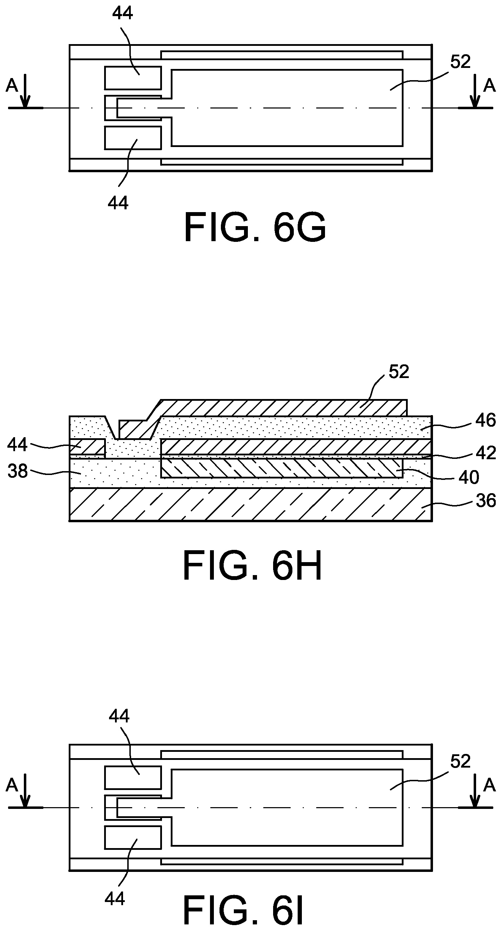

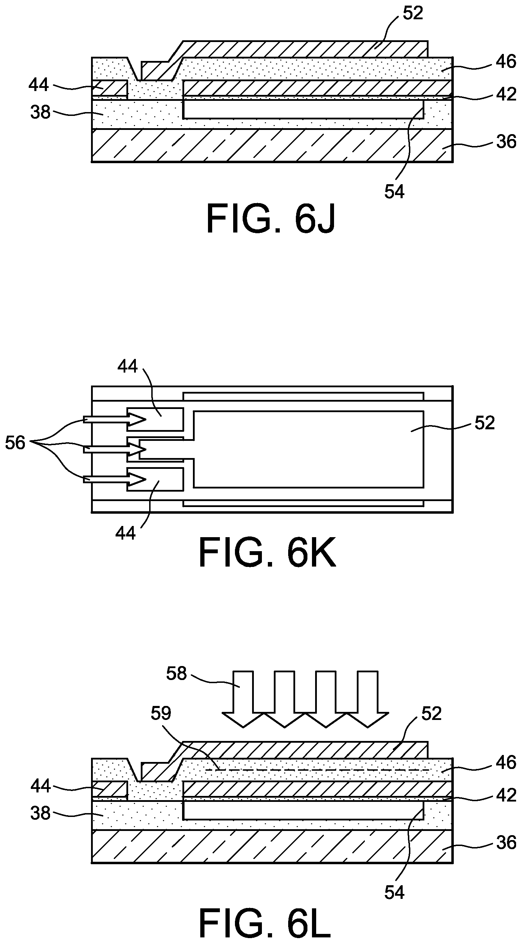

- On dépose une couche 38 de $SiO_2$, de 2 μm d'épaisseur, par PECVD à 770°C.
- Par une première lithographie, on définit le caisson de la cavité de libération de la « membrane » finale, c'est-à-dire du résonateur finalement formé.
- On effectue une gravure de 1 μm du $SiO_2$ par gravure sèche ($CHF_3/O_2$).
- On effectue un retrait de la résine (en anglais, *resist*) ayant servi à la gravure.
- On dépose 2 μm de polysilicum par CVD.
- On effectue un polissage mécano-chimique (CMP) du polysilicium avec arrêt sur le $SiO_2$, pour obtenir un caisson 40 de polysilicium, de 1 μm d'épaisseur.
- On dépose une couche de nucléation 42 (en anglais, *seed layer*) en AlN, de 20 nm d'épaisseur (pour améliorer l'orientation cristalline de l'électrode inférieure à former), par pulvérisation cathodique (voir la figure 6C : vue de dessus ; et la figure 6D : coupe AA de la figure 6C).
- On dépose une couche d'électrode inférieure en platine, de 200 nm d'épaisseur, par pulvérisation cathodique.
- Par une deuxième lithographie, on définit l'électrode inférieure 44.
- On grave l'électrode inférieure 44 et la couche de nucléation 42 par usinage ionique. La zone gravée a la référence 45.
- On effectue le retrait de la résine ayant servi à cette gravure.
- On dépose une couche de matériau piézoélectrique 46, à savoir 1 μm d'AlN, par pulvérisation cathodique (voir la figure 6E : vue de dessus ; et la figure 6F : coupe AA de la figure 6E).
- On effectue une troisième lithographie pour définir deux zones 48 de contact de l'électrode inférieure 44. La référence 50 représente la zone où AlN est en contact avec $SiO_2$.
- On effectue une gravure chimique de l'AlN par $H_3PO_4$ à 130°C.
- On effectue un retrait de la résine ayant servi à cette gravure.
- On dépose une couche d'électrode supérieure en platine, de 200nm d'épaisseur, par pulvérisation cathodique (figure 6G : vue de dessus ; figure 6H : coupe AA de la figure 6G).
- Par une quatrième lithographie, on définit l'électrode supérieure 52.
- On effectue une gravure sèche du platine de l'électrode supérieure par usinage ionique, afin de définir le motif de l'électrode supérieure.
- On effectue un retrait de la résine ayant servi à cette gravure.
- On effectue une gravure sèche par $XeF_2$ du polysilicium 40 (figure 6I : vue de dessus ; figure 6J : coupe AA de la figure 6I).
- Une cavité 54 se forme ainsi sous le résonateur et le libère. La libération de la membrane constituée par le résonateur peut aussi être obtenue par une gravure du substrat 36 en silicium, par la face arrière de ce dernier. Il s'agit alors d'une gravure profonde dans ce substrat.
- On mesure les fréquences caractéristiques du résonateur à l'aide d'un analyseur de réseau (non représenté). Les flèches 56 de la figure 6K (vue de dessus du résonateur) représentent les connexions de l'analyseur à l'électrode inférieure 44 et à l'électrode supérieure 52 pour la mesure.
- On effectue le chargement du résonateur (voir la figure 6L : vue en coupe) à l'aide d'une implantation électronique ou ionique (les flèches 58 symbolisent l'injection des charges qui peuvent être positives ou négatives), avec une énergie suffisante pour traverser la couche métallique, constituée par l'électrode supérieure 52 (la décharge Corona ne permettrait pas de traverser cette dernière). Les charges implantées ont la référence 59. La charge choisie correspond à celle qui permet de recaler le résonateur à la bonne fréquence, sachant que le coefficient de variation de fréquence d'antirésonance de l'AlN en fonction du champ électrique continu est égal à 0,25 Hz.m/V d'après la thèse de R. Lanz, mentionnée plus haut.
- Le résonateur défini par l'empilement que l'on a formé a une fréquence de résonance de 1,870 GHz et une fréquence d'antirésonance de 1,918 GHz avant l'application de la charge électrique.
- Après l'application d'une charge correspondant à un potentiel de +100 V, la fréquence d'antirésonance vaut 1,943 GHz, d'où une variation relative de fréquence de +1,3%.

Le deuxième exemple est identique au premier, excepté que l'on utilise la décharge Corona pour charger le diélectrique (couche d'AlN). On effectue alors le chargement de ce dernier avant le dépôt de l'électrode supérieure.

Il n'y a donc pas de mesure des fréquences caractéristiques avant d'avoir chargé la couche d'AlN. On ne sait donc pas combien de charges on doit mettre dans cette couche.

Cependant, on peut ajuster la tension en faisant migrer les charges dans le diélectrique, en chauffant le résonateur après avoir déposé l'électrode supérieure, et donc après avoir pu mesurer les fréquences caractéristiques. Le chauffage du résonateur peut se faire de typiquement entre 20°C et 700°C, par exemple à l'aide d'un four ou d'un chauffage localisé (par exemple à l'aide d'un laser).

Les diverses étapes du procédé correspondant au deuxième exemple sont données ci-après.

Les références utilisées dans le premier exemple ont été conservées pour désigner les mêmes éléments.

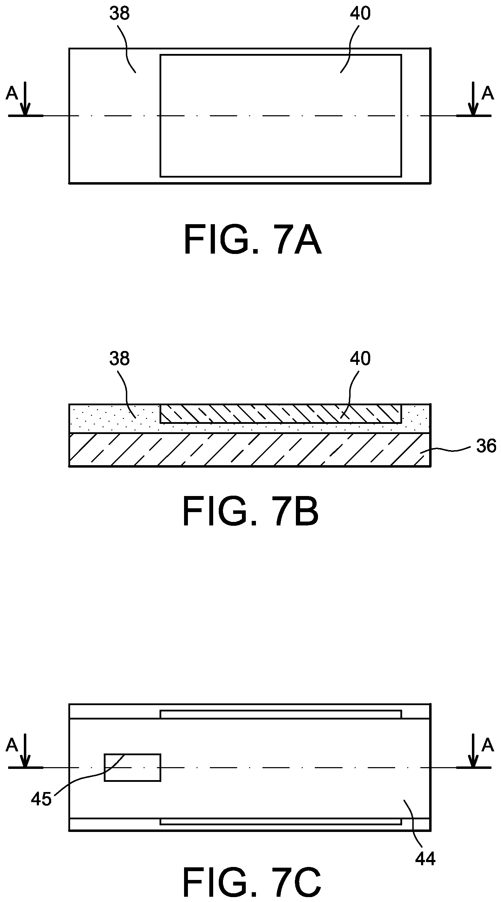

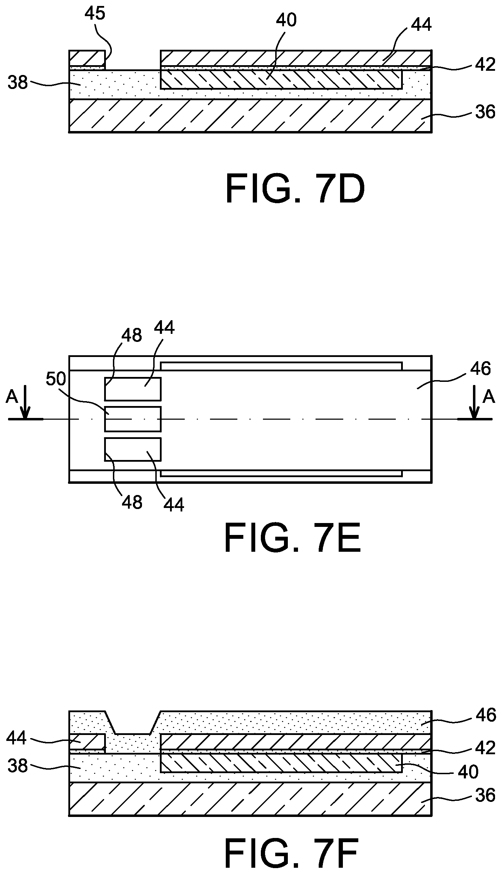

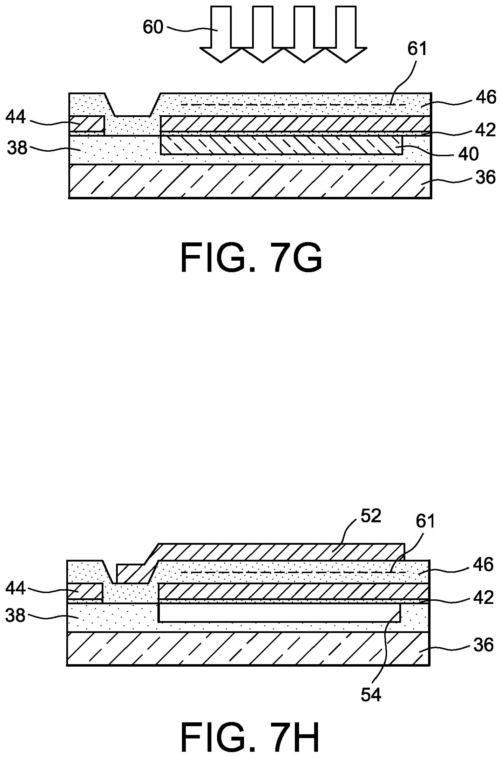

- On part du substrat de silicium 36 de 200 mm de diamètre, d'épaisseur typique 700 μm (figure 7A : vue de dessus du résonateur en cours de fabrication ; figure 7B : coupe AA de la figure 7A).
- On dépose la couche 38 de $SiO_2$, de 2 μm d'épaisseur, par PECVD à 770°C.
- Par une première lithographie, on définit le caisson de la cavité de libération de la membrane finale.
- On grave 1 μm de la couche 38 de $SiO_2$ par gravure sèche ($CHF_3/O_2$).
- On effectue un retrait de la résine ayant servi à cette gravure.
- On dépose 2 μm de polysilicum par CVD.
- On effectue un polissage mécano-chimique (CMP) du polysilicium avec arrêt sur $SiO_2$, pour obtenir le caisson 40 de polysilicium, de 1 μm d'épaisseur.
- On dépose la couche de nucléation 42 en AlN, de 20 nm d'épaisseur (pour améliorer l'orientation cristalline de l'électrode inférieure à former), par pulvérisation cathodique (figure 7C : vue de dessus ; figure 7D : coupe AA de la figure 7C).
- On dépose l'électrode inférieure 44 en platine, de 200nm d'épaisseur, par pulvérisation cathodique.
- Par une deuxième lithographie, on définit cette électrode inférieure.
- On effectue la gravure de l'électrode inférieure 44 et de la couche de nucléation 42 par usinage ionique. La zone gravée a la référence 45.
- On effectue le retrait de la résine ayant servi à cette gravure.
- On dépose la couche piézoélectrique 46 en AlN, de 1 μm d'épaisseur, par pulvérisation cathodique (figure 7E : vue de dessus ; figure 7F : coupe AA de la figure 7E).
- Par une troisième lithographie, on définit deux zones 48 de contact de l'électrode inférieure 44. La référence 50 représente la zone où AlN est en contact avec $SiO_2$.
- On effectue une gravure chimique de l'AlN par $H_3PO_4$ à 130°C.
- On effectue le retrait de la résine ayant servi à cette gravure.
- Par la technique de décharge Corona, on injecte des charges électriques (qui peuvent être positives ou négatives dans le diélectrique (AlN). On choisit une tension de l'ordre de 100 V pour cette injection. L'injection des charges est symbolisée par les flèches 60 sur la figure 7G (vue en coupe). Les charges électriques implantées ont la référence 61.
- On dépose une couche d'électrode supérieure en platine, de 200nm d'épaisseur, par pulvérisation cathodique (figure 7H : vue en coupe).
- Par une quatrième lithographie, on définit l'électrode supérieure 52.
- On effectue une gravure sèche de cette électrode supérieure par usinage ionique.
- On effectue le retrait de la résine ayant servi à cette gravure.
- On effectue une gravure sèche, par $XeF_2$, du polysilicium 40.
- La cavité 54 se forme ainsi sous le résonateur et le libère. La libération de la membrane constituée par ce résonateur peut aussi être obtenue par gravure du substrat 36 en silicium, par la face arrière de ce dernier. Il s'agit alors d'une gravure profonde dans ce substrat.
- On mesure les fréquences caractéristiques du résonateur à l'aide d'un analyseur de réseau (non représenté).
- - On ajuste les fréquences en chauffant le résonateur. Ce chauffage permet de faire migrer les charges dans le diélectrique (couche d'AlN) et donc de faire varier la tension continue, subie par le diélectrique.

Remarquons que dans ce deuxième exemple, rien n'empêche d'utiliser une implantation ionique ou électronique à la place de la décharge Corona.

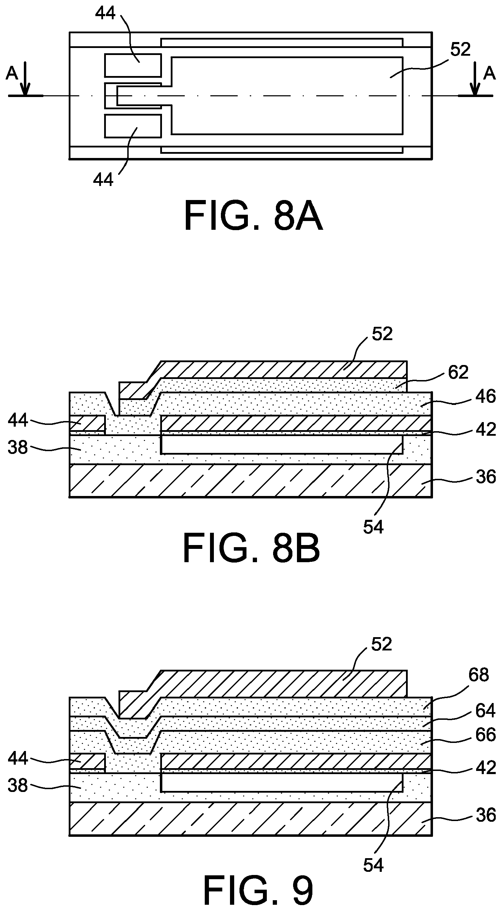

Dans un troisième exemple (figure 8A : vue de dessus ; figure 8B : coupe AA de la figure 8A), on ajoute une couche 62 de $SiO_2$, de 200 nm d'épaisseur, entre l'électrode inférieure 44 et l'électrode supérieure 52. Cette couche 62 peut être adjacente à la couche 46 en AlN, ce qui est le cas sur la figure 8. Mais elle peut aussi être dans l'AlN ; en d'autres termes, cette couche 62 peut être comprise entre deux couches d'AlN.

La silice ($SiO_2$) constitue un matériau reconnu en tant que diélectrique pour les électrets. Ce matériau est en effet capable de bien conserver des charges électriques qui y ont été injectées.

A ce sujet, on se reportera à l'article de P. Gunther, Charging, Long-term Stability, and TSD measurements of SiO2 electrets, IEEE Transactions on electrical insulation, vol. 24, n°3, Juin 1989, et aussi à l'article de V. Leonov et al., Stabilization of Positive Charge in SiO2/Si3N4 Electrets, IMEC, IEEE Transactions on Dielectrics and Electrical Insulation, vol. 13, n°5, Octobre 2006.

Le procédé de fabrication est le même que pour le premier exemple, en ajoutant toutefois une étape de dépôt de $SiO_2$ par PECVD, au-dessus de la couche d'AlN, avant le dépôt de l'électrode supérieure. La couche de $SiO_2$ ainsi déposée sera gravée avec la même lithographie que celle qui est utilisée pour l'électrode supérieure, par gravure sèche à l'aide de $CHF_3/O_2$ ou par gravure humide à l'aide de HF. A la fin du procédé, la structure obtenue est telle qu'on la voit sur les figures 8A et 8B.

La couche de $SiO_2$ est ainsi au-dessus de la couche d'AlN. Mais il est également possible de former la couche

de $SiO_2$ avant la couche d'AlN.

Le chargement de l'électret se fait de la même façon que dans les premier et deuxième exemples. Cas du premier exemple :

- dépôt de l'AlN,
- dépôt de la couche de diélectrique, destinée à devenir une couche d'électret,
- chargement par décharge Corona ou par implantation électronique ou ionique,
- dépôt de l'électrode supérieure,
- mesure des fréquences caractéristiques du résonateur.

La variation de la fréquence finale peut alors se faire par chauffage de la structure car la température permet de donner de la mobilité aux charges piégées dans l'électret.

La séquence d'ajustement de la fréquence se fait donc de la manière suivante : mesure des fréquences caractéristiques, comparaison avec la fréquence cible, chauffage (la température de recuit dépend du diélectrique mais reste de l'ordre de grandeur d'une centaine de degrés, voire de quelques centaines de degrés), mesure des fréquences caractéristiques, jusqu'à ce que la fréquence souhaitée soit atteinte.

Cas du deuxième exemple :

- dépôt de l'AlN,
- dépôt de la couche de diélectrique, destinée à devenir un électret,
- dépôt de l'électrode supérieure,
- mesure des fréquences caractéristiques du résonateur,
- chargement par implantation électronique ou ionique de la couche de diélectrique ; la charge est choisie de sorte que la tension continue finale dans l'AlN soit de l'ordre d'une centaine de volts, sachant que le coefficient de variation de fréquence d'antirésonance de l'AlN, en fonction du champ électrique continu, vaut 0,25 Hz.m/V d'après la thèse de R. Lanz, mentionnée plus haut.

Un autre avantage d'utiliser la silice pour former l'électret est que la silice permet de compenser la dérive en température du résonateur comportant cet électret.

Il convient de noter qu'on peut utiliser d'autres matériaux que $SiO_2$ en tant qu'électrets, notamment le nitrure de silicium.

On donne ci-après un quatrième exemple.

Dans l'empilement correspondant à ce quatrième exemple, l'électret est placé dans le matériau piézoélectrique (voir la figure 9). L'empilement devient ainsi : électrode inférieure 44 en platine, de 200 nm d'épaisseur - couche piézoélectrique 66 en AlN, de 0,5 $\mu$m d'épaisseur - couche 64 de $SiO_2$, de 200 nm d'épaisseur - couche 68 en AlN, de 0,5 $\mu$m d'épaisseur - électrode supérieure 52 en platine, de 200 nm d'épaisseur.

L'avantage d'un tel empilement par rapport au précédent est qu'il permet d'éloigner les charges électriques stockées dans l'électret des électrodes. Cela permet d'augmenter la tension que l'on peut appliquer, sans claquer les diélectriques. Le chargement électrique peut se faire de la même façon que dans les exemples précédents : soit juste après le dépôt du diélectrique destiné à former l'électret, soit juste après le dépôt d'AlN, soit après le dépôt de l'électrode supérieure.

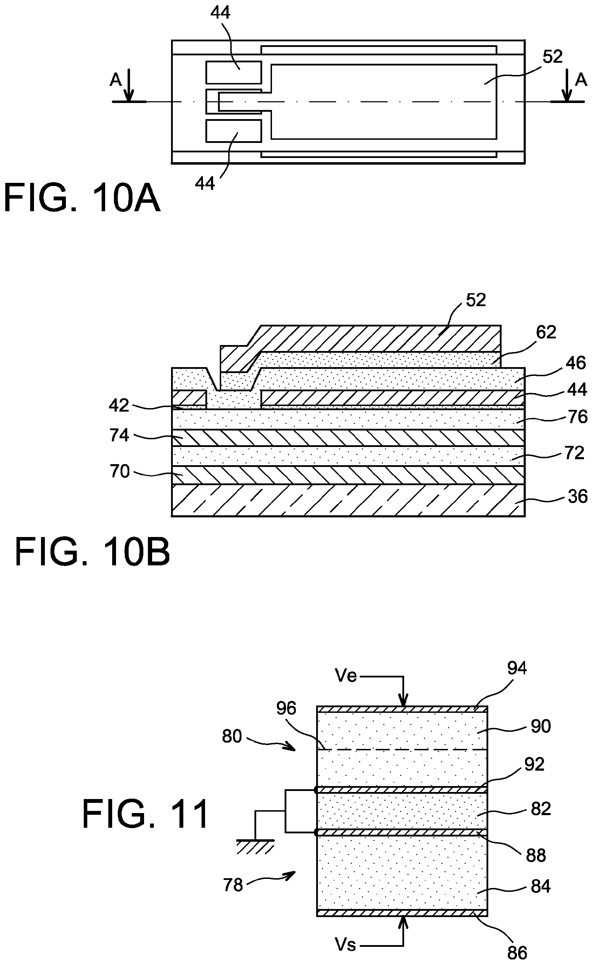

On décrit maintenant un cinquième exemple, en faisant référence à la figure 10A (vue en coupe), et à la figure 10B (coupe AA de la figure 10A).

Les quatre exemples précédents étaient relatifs à des FBAR, c'est-à-dire des résonateurs sur une cavité.

Il est également possible de former ces résonateurs sur des réseaux de Bragg acoustiques, encore appelés miroirs de Bragg acoustiques.

Des résonateurs ont déjà été formés sur de tels miroirs.

A ce sujet, on se reportera par exemple à l'article de A. Volatier et al., Design, elaboration and characterization of coupled resonator filters for WCDMA applications, Ultrasonic symposium, Vancouver BC, 2006, pages 829-832.

La fabrication est la même que précédemment, à l'exception du début et de la libération finale qui n'est plus nécessaire.

On commence par former un miroir de Bragg acoustique sur le substrat 36. Pour ce faire, on dépose une couche de tungstène 70, de 670 nm d'épaisseur, par pulvérisation cathodique sur le substrat 36, puis une couche 72 de $SiO_2$, de 800 nm d'épaisseur, par PECVD, puis à nouveau une couche de tungstène 74, de 670 nm d'épaisseur, puis à nouveau une couche 76 de $SiO_2$, de 800 nm d'épaisseur.

La formation de l'empilement se poursuit avec la formation de la couche de nucléation 42 en AlN, de 20nm d'épaisseur.

Et ainsi de suite, comme pour les précédents empilements.

Pour l'empilement que l'on voit sur la figure 10B, il n'est pas nécessaire de libérer le résonateur avec $XeF_2$ car le miroir de Bragg joue le rôle d'isolation acoustique. Le choix des épaisseurs des couches constitutives du miroir est connu dans l'état de la technique. On se reportera par exemple à l'article de A. Volatier et al. mentionné ci-dessus.

Bien entendu, ce miroir de Bragg peut être « combiné » à tous les exemples précédents : au lieu d'être au-dessus d'une cavité, les résonateurs sont au-dessus d'un miroir de Bragg.

Le chargement du diélectrique ($SiO_2$) pour former l'électret se fait exactement comme dans les exemples précédents. On peut également enlever ce diélectrique et ne conserver que l'AlN en tant qu'électret, comme dans le premier exemple.

Le résonateur acoustique, objet de l'invention, s'applique aux filtres commutables à résonateurs couplés.

Au sujet de tels filtres, on se reportera au brevet FR 2 905 207, filtre commutable à résonateurs, invention de **A. Volatier et al**., ou au brevet US 2008/129416 qui correspond au brevet FR 2 905 207. Dans de tels filtres, deux résonateurs acoustiques sont placés l'un sur l'autre et couplés acoustiquement l'un à l'autre (voir l'article de A. Volatier et al., Design, elaboration ... applications, déjà cité plus haut).

Pour mettre en oeuvre la présente invention, on peut alors charger électriquement le diélectrique du résonateur supérieur ou le diélectrique du résonateur inférieur.

La figure 11 est une vue en coupe schématique d'un filtre commutable à résonateurs couplés, conforme à l'invention. On voit le résonateur inférieur 78, le résonateur supérieur 80 et des moyens 82 pour coupler acoustiquement ces résonateurs l'un à l'autre.

Le résonateur 78 comprend une couche de matériau piézoélectrique 84 entre deux électrodes 86 et 88. De même, le résonateur 80 comprend une couche de matériau piézoélectrique 90 entre deux électrodes 92 et 94.

Dans l'exemple, on a injecté des charges électriques 96 dans la couche 90 qui sert alors à la fois de couche résonante et d'électret. Bien entendu, on pourrait prévoir une couche résonante et une couche d'électret distinctes dans ce résonateur, ou toute autre variante de l'invention.

Pour l'utilisation du filtre schématiquement représenté sur la figure 11, les électrodes 88 et 92 sont mises à la masse, un signal d'entrée Ve est appliqué à l'électrode 94 et un signal de sortie V1 est récupéré sur l'électrode 86.

On peut aussi utiliser l'invention pour appliquer une tension continue à des matériaux électrostrictifs tels que $(Ba,Sr)TiO_3$ (BST), (Pb,La) $(Zr,Ti)O_3$, $Pb(Mb,Nb,Ti)O_3$ afin de leur conférer un champ électrique permanent.

Un matériau électrostrictif pour lequel on adjoint une tension continue au signal d'excitation devient piézoélectrique induit (voir par exemple l'article de A. Volatier et al., Switchable and tunable strontium titanate electrostrictive bulk acoustic wave resonator integrated with a Bragg mirror, Applied Physics Letters, vol. 92, n°3, 2008, p. 032906-032909).

Appliquer des charges électriques sur un tel matériau par l'intermédiaire d'un électret adjacent ou bien directement dans le matériau électrostrictif permet alors de créer des résonateurs (ou des actionneurs) pour lesquels il n'est plus nécessaire d'appliquer une tension continue en fonctionnement, pour peu que les charges restent dans l'électret. On peut ainsi former d'autres résonateurs acoustiques conformes à l'invention, en reprenant tous les empilements précédemment décrits et en y remplaçant l'AlN par un matériau électrostictif tel que le BST par exemple.

On revient ci-après sur la décharge Corona.

La décharge Corona est généralement utilisée dans les photocopieurs, pour la production d'ozone ou encore pour améliorer la mouillabilité de certains matériaux.

Dans le cas de la présente invention, son but est d'injecter des charges dans un matériau diélectrique qui est capable de les conserver pendant une longue période (typiquement plusieurs années) : il s'agit d'un électret. Il en résulte l'apparition d'un potentiel de surface et la création d'un champ électrique au sein du matériau. Il s'agit d'un dipôle électrique, au même titre que l'aimant permanent est un dipôle magnétique.

Afin de contrôler la valeur du champ électrique permanent, il est généralement plus aisé de contrôler le potentiel de surface de l'échantillon. En effet, grâce au système Corona triode (pointe 6/grille 8/électrode 4 - voir figure 2), le potentiel de surface de l'échantillon 2 ($V_s$) prend la valeur du potentiel imposé à la grille ($V_g$) et ainsi :

$$E = \frac{V_s}{d} = \frac{V_g}{d}$$

où d est l'épaisseur de l'échantillon et E le champ électrique.

La quantité des charges qui sont présentes dans le matériau de l'échantillon dépend de l'épaisseur de ce matériau (d), de sa constante diélectrique ($\varepsilon$) et de la capacité du matériau à conserver préférentiellement les charges à sa surface, en profondeur, ou, pour des systèmes multicouches, aux interfaces.

On estime ainsi que si un matériau conserve ses charges (Q) à la surface (S), alors la densité surfacique de charge ($\sigma$) vaut :

$$\sigma = \frac{Q}{S} = \frac{\varepsilon\varepsilon_0 V_s}{d}$$ ($\varepsilon_0$ : permittivité du vide).

Dans le cas d'un stockage en profondeur, il est plus difficile de déterminer la densité volumique de charge ($\rho$) dans le matériau.

Un ordre de grandeur typique est une charge de 2 $mC/m^2$ qui correspond à un potentiel de surface de 200 V sur 500 nm de $SiO_2$.

Le chargement peut être réalisé sous des conditions standard de température et de pression (20°C à $10^5$ Pa) ; néanmoins, il n'est pas exclu de le réaliser sous d'autres conditions et notamment à de plus hautes températures ou de plus basses pressions et inversement. Il n'est pas non plus exclu de chauffer l'échantillon pendant son chargement, ceci ayant généralement pour effet d'augmenter la profondeur de pénétration des charges dans le matériau ainsi que la stabilité.

Le chargement est généralement réalisé à l'air ambiant ($0_2$ : 20%, $N_2$ : 80%) . Néanmoins, il n'est pas exclu de changer ces ratios, voire de changer de gaz.

La tension de la pointe ($V_p$) est de l'ordre de grandeur de quelques kilovolts. La tension de la grille ($V_g$) peut varier entre 0 V et 500 V. Les deux valeurs peuvent être positives (Corona+) ou négatives (Corona-). Ces tensions peuvent, par exemple, être obtenues à l'aide de convertisseurs DC/HT.

Généralement, l'espace entre la pointe et la grille, de même que l'espace entre la grille et l'échantillon, est de l'ordre de 1 cm. Les trous de la grille ont, quant à eux, une taille millimétrique.

Pour le chargement, on peut utiliser une autre technique, à savoir la méthode de l'électrode humide (encore appelée méthode de l'électrode liquide), au lieu de la décharge Corona.

Au sujet de cette méthode, on pourra se reporter à l'article de K. Ikezaki et al., Thermally Stimulated Currents from Ion-Injected Teflon-FEP Film Electrets, Jpn. J. Appl. Phys. 20 (1981) pp. 1741-1747.

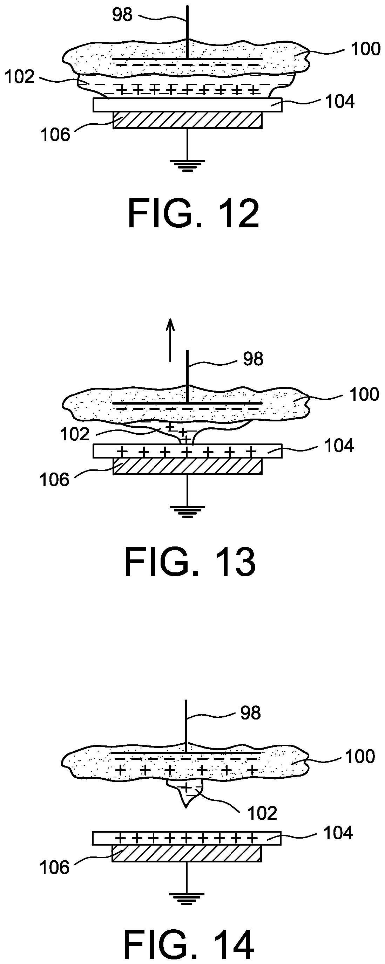

Le principe de cette méthode est schématiquement illustré par les figures 12, 13 et 14.

Sur ces figures, la référence 98 désigne une électrode supérieure en platine, la référence 100 un tampon en coton, la référence 102 une solution aqueuse d'électrolytes, la référence 104 une couche constituant un échantillon, et la référence 106 une électrode inférieure qui porte l'échantillon et qui est mise à la masse.

L'électrode supérieure est chargée négativement (par des moyens appropriés, non représentés) et entourée du tampon 100. Et l'électrode supérieure se trouve sur l'échantillon.

Dans une première étape (figure 12), on approche l'électrode supérieure de la solution. Cette dernière et l'échantillon se chargent alors positivement par influence.

Dans une deuxième étape (figure 13), la solution est absorbée par le tampon et les charges positives restent sur l'échantillon. On éloigne alors l'électrode supérieure pourvue du tampon imbibé de la solution.

Une fois l'électrode supérieure escamotée, on dispose donc d'un échantillon chargé positivement sur l'électrode 106 (figure 14).

On donne ci-après des détails sur le procédé Smart Cut™ qui est utilisable dans la présente invention pour former la couche piézoélectrique et/ou la couche d'électret.

Afin de réaliser une couche fine de matériau monocristallin, on peut avantageusement avoir recours à deux types de techniques existantes de report de couches minces, permettant de conserver le caractère monocristallin : la technologie Smart Cut™, basée sur l'implantation d'ions gazeux (typiquement des ions hydrogène), et la technique de collage/amincissement.

Ces techniques sont des techniques uniques qui permettent de reporter une couche monocristalline sur un substrat hôte. Ces techniques sont parfaitement maîtrisées sur le silicium et permettent entre autres la fabrication industrielle de plaquettes SOI (pour Silicon On Insulator).

Ces deux techniques se différencient par la gamme des épaisseurs de matériau que l'on cherche à reporter, le procédé Smart Cut™ permettant d'atteindre de très faibles épaisseurs qui peuvent être typiquement inférieures à environ 0,5 $\mu$m.

Le procédé Smart Cut™ (voir l'article de M. Bruel, Silicon on insulator material technology, Electronic letters, 31 (14), p.1201-1202, 1995), permet la réalisation de substrats SOI, comprenant du silicium sur un isolant.

La technologie Smart Cut™ peut être schématiquement résumée par les quatre étapes essentielles suivantes :

Etape 1 : L'implantation d'hydrogène est réalisée sur un substrat A de Si oxydé. La couche d'oxyde constitue alors le futur film d'isolant enterré de la structure SOI. Cette étape d'implantation génère la formation d'une zone fragilisée en profondeur, laquelle est constituée de microcavités dont la croissance est à la base du phénomène de détachement.

Etape 2 : Le collage par adhésion moléculaire permet de solidariser la plaque implantée A sur la plaque support (contre-plaque ou base) B qui n'est pas forcément oxydée. Une préparation de surface est nécessaire à l'obtention d'un collage de bonne qualité.

Etape 3 : L'étape de fracture est effectuée au niveau de la zone fragilisée au moyen d'un traitement thermique dans la gamme des 400°C-600°C. On obtient d'une part la structure SOI, et d'autre part le substrat initialement implanté A, pelé de la couche transférée. Ce dernier peut alors être recyclé pour la réalisation d'un autre transfert.

Etape 4 : Des traitements finaux sont constitués, d'une part, d'un recuit à haute température pour consolider l'interface de collage entre le film mince transféré et le substrat support et, d'autre part, d'un polissage qui permet d'obtenir l'épaisseur finale de film superficiel de silicium désirée, ainsi qu'un bon état de surface.

L'épaisseur de la couche transférée est directement reliée à l'énergie d'implantation du faisceau d'ions, et permet donc d'obtenir une bonne flexibilité au niveau des combinaisons d'épaisseurs (film mince et oxyde enterré). A titre d'exemple, l'épaisseur de silicium transférée peut aller de quelques dizaines de nanomètres à environ 2 $\mu$m en utilisant un implanteur classique (énergie inférieure à 210 keV).

Les couches transférées sont uniformes et homogènes en épaisseur car elles sont définies par une profondeur d'implantation et non par un amincissement mécanique.

Les coûts de fabrication sont réduits, d'une part, par le recyclage des substrats (les plaques initialement implantées peuvent être réutilisées après transfert du film mince), et d'autre part, par l'utilisation d'équipements standard en microélectronique.

C'est un procédé flexible qui permet par exemple la réalisation d'hétérostructures. Ainsi, la technologie Smart Cut™ permet par exemple de coupler les avantages d'un substrat support en Si massif (notamment coût, poids et caractéristiques mécaniques) et d'une couche mince active. On peut ainsi réaliser le transfert de couches de différents matériaux tels que :

- le SiC - voir L. DiCioccio et al., « Silicon carbide on insulator formation by Smart Cut™ process », Master, Sci. Eng. vol. B46, pp.349-356 (1997) ;
- le GaAs - voir E. Jalaguier et al., « Transfer on thin GaAs film on silicon substrate by proton implantation process », Electronic letters, vol.34, n°4, pp.408-409 (1998) ;
- l'InP - voir E. Jalaguier et al., « Transfer of thin InP film onto silicon substrate by proton implantation process », IEEE Proc.11th International Conference on Indium Phosphide and Related Materials, Davos (Suisse) (1999) ;
- le GaN - voir A. Tauzin et al., « Transfers of 2- inch GaN films onto sapphire substrates using Smart CutTM technology », Electronics Letters 2005, vol. 41, N°11;
- ou le Ga - voir C. Deguet et al. - « 200 mm Germanium-On-Insulator (GeOI) structures realized from epitaxial Germanium wafers by the Smart Cut™ technology », Electro Chemical Society 2005.

Ces transferts peuvent être réalisés sur différents substrats, notamment quartz, Si, Ge, GaAs et saphir.

On revient à présent sur le miroir de Bragg.

Une solution pour isoler le résonateur acoustique de type BAW (pour Bulk Acoustic Wave) du substrat est fondée sur un principe très largement exploité en optique : le miroir de Bragg.

Sa transposition acoustique consiste à réaliser sous le résonateur un empilement dans lequel des couches quart d'onde de matériaux à basse impédance acoustique alternent avec des couches quart d'onde de matériaux à haute impédance acoustique. Dans cette configuration, les résonateurs sont aussi appelés SMR (pour Solidly Mounted Resonator).

Cette idée, proposée dès 1965 - voir l'article de W.E. Newell, Face-mounted piezoelectric resonators, Proc. of IEEE, pp. 575-581, 1965 - pour les résonateurs à quartz, a été reprise dans les résonateurs BAW SMR réalisés par K.M. Lakin et al., Development of miniature filters for wireless applications, IEEE Trans. Microwave Theory. Tech., vol. 43, n°12, pp. 2933-2939, 1995.

Dans le cas du miroir de Bragg, le coefficient de réflexion dépend des matériaux et du nombre de couches utilisés et n'est pas constant sur toute la bande de fréquence. Nous allons donc préciser les paramètres-clefs et les caractéristiques de la réponse d'un miroir de Bragg.

Il est possible de calculer le coefficient de réflexion que présente un miroir de Bragg pour une onde longitudinale en utilisant un modèle de type ligne de transmission - voir l'article de K.M. Lakin, Fundamental properties of thin film resonators, IEEE Freq. Contr. Symp., pp.201-206, 1991. Ce modèle permet de représenter l'impédance acoustique $Z_n$ présentée par une couche en fonction de l'impédance acoustique de la couche inférieure $Z_{n-1}$ par l'expression :

$$Z_n = Z_{mat} \cdot \left( \frac{Z_{n-1}.\cos(\theta_{mat}) + i.Z_{mat}.\sin(\theta_{mat})}{Z_{mat}.\cos(\theta_{mat}) + i.Z_{n-1}.\sin(\theta_{mat})} \right),$$

où $\theta_{mat} = \frac{\omega . e_{mat}}{V_{mat}}$ est la pulsation et $Z_{mat}$, $e_{mat}$ et $V_{mat}$ sont respectivement l'impédance acoustique, l'épaisseur et la vitesse de l'onde longitudinale de la couche.

A partir de cette expression, il est possible de déterminer l'impédance $Z_{Bragg}$ présentée par le miroir de Bragg à l'interface entre l'électrode inférieure et le miroir de Bragg. Le coefficient de réflexion R pour l'onde longitudinale s'écrit :

$$R = \frac{Z_{elec} - Z_{Bragg}}{Z_{elec} + Z_{Bragg}},$$

où $Z_{elec}$ représente l'impédance acoustique de l'électrode inférieure.

Le coefficient de réflexion présenté par le miroir de Bragg est fonction du nombre de couches. Le couple de matériaux $SiO_2$/W est couramment utilisé car il permet, à partir de quatre couches, de remplir la fonction d'isolation acoustique.

Le nombre de couches nécessaire augmente lorsqu'on utilise des matériaux qui présentent un plus faible rapport des impédances acoustiques. Ainsi, dans le cas du couple $SiO_2$/AlN, qui fut un des premiers à être exploité, deux couches sont nécessaires pour atteindre une réflexion suffisante - voir l'article de M.A. Dubois, Aluminium nitride and lead zirconate-titanate thin films for ultrasonics applications : integration, properties and devices, Thèse de l'EPFL, 1999.

Le rapport des impédances acoustiques définit également la largeur de la bande passante de réflexion du miroir de Bragg. Plus le rapport des impédances acoustiques est élevé, plus la plage de fréquences sur laquelle le miroir de Bragg présente une bonne réflexion est grande. Ainsi, cette bande de réflexion pour un miroir à six couches atteint 1,5 GHz pour le couple $SiO_2$/AlN et 2,8 GHz pour le couple $SiO_2$/W.

Le couple $SiO_2$/W présente donc l'avantage d'utiliser peu de couches et de présenter une plage de réflexion très large. En revanche, son intégration dans des filtres BAW nécessite de graver le tungstène en dehors des zones actives afin d'éviter des couplages capacitifs parasites.

On donne ci-après des informations sur différents types de filtres. Ces informations sont utiles, dans la présente invention, car il est possible d'améliorer la réponse des filtres avec des électrets notamment en améliorant les pertes d'insertion.

Deux types de topologies, fondées sur le couplage électrique de résonateurs, sont utilisables pour la réalisation de filtres passe-bande radiofréquence de type BAW : la topologie en échelle et la topologie en treillis.

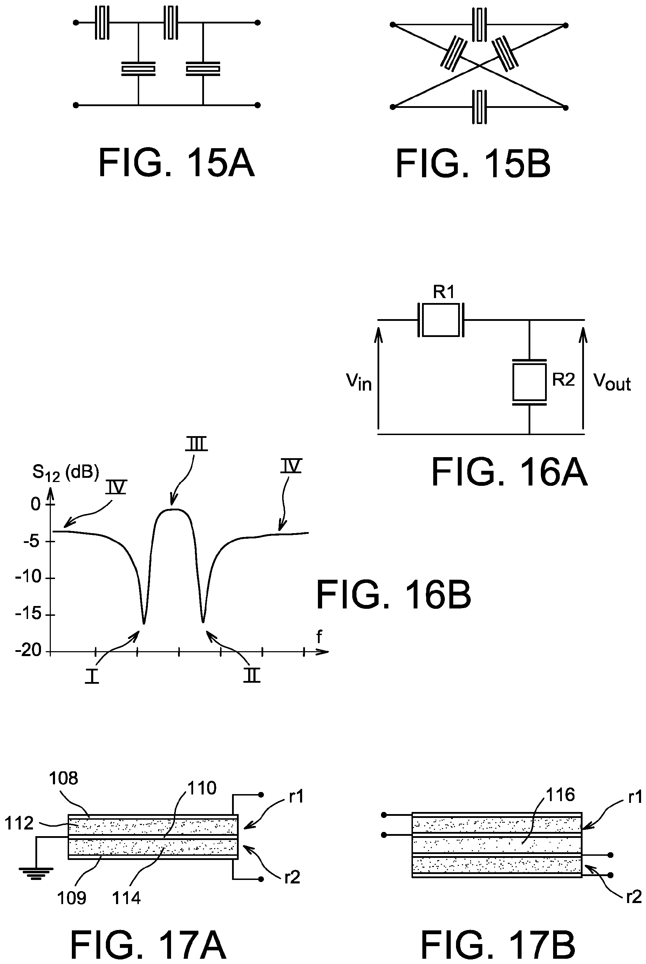

Le filtre en treillis représenté sur la figure 15B a été développé dès 1929 par W.P. Watson. Il est particulièrement utilisé pour ses bonnes performances en termes d'atténuation hors bande malgré une faible sélectivité. Ses propriétés de symétrie en font d'autre part un filtre bien adapté pour les architectures différentielles.

La topologie en échelle (voir figure 15A) a été proposée par L. Espenchied en 1927. A l'inverse du filtre en treillis, ce type de filtre possède une très bonne sélectivité mais un niveau de réjection hors bande médiocre.

Pour réaliser ces deux filtres, il est nécessaire de disposer de deux types de résonateurs possédant des fréquences différentes. Le décalage en fréquence peut s'obtenir à partir d'un résonateur standard, en ajoutant une couche supplémentaire pour abaisser la fréquence ($SiO_2$ par exemple), ou en gravant la couche supérieure pour augmenter la fréquence.

Ce décalage en fréquence est un point très sensible de la fabrication de ces filtres car il joue au premier ordre sur la largeur de la bande passante ainsi que sur le niveau de pertes d'insertion.

La figure 16A montre une cellule de base de ce type de filtre (Vin : tension d'entrée ; Vout : tension de sortie). Etant donné la disposition des résonateurs, la fréquence d'antirésonance du résonateur en « parallèle » R2 doit être décalée pour coïncider avec la fréquence de résonance du résonateur en « série » R1. On se reportera à la figure 16B où le paramètre $S_{12}$ (en dB) est représenté en fonction de la fréquence f (unités arbitraires). La zone I correspond à la résonance de R2, la zone II à l'antirésonance de R1, la zone III à la résonance de R1 et à l'antirésonance de R2, et les zones IV à aucune des résonances et donc simplement au pont des deux capacités.

Sur ce type d'architecture très simplifié on retrouve l'influence des performances du résonateur. La largeur de bande passante est directement liée au coefficient de couplage électromécanique $k_I^2$. Le niveau de pertes d'insertion est lié aux pertes dans les résonateurs et donc au facteur de qualité. Enfin, le facteur de qualité va également influencer la sélectivité du filtre.

L'un des avantages de ces filtres est la relative simplicité de fabrication puisqu'il suffit d'utiliser une seule couche supplémentaire par rapport à la fabrication d'un résonateur pour pouvoir réaliser un filtre même complexe.

Par ailleurs, ces deux architectures, avec leurs propriétés complémentaires, donnent une bonne flexibilité en termes de conception. Récemment, des travaux ont d'ailleurs vu le jour sur l'utilisation d'architectures mixtes échelle/treillis, permettant de coupler à la fois les avantages d'une bonne réjection hors bande et d'une bonne sélectivité (voir A. Shirakawa et al., A high isolation and high selectivity Ladder-Lattice BAW BAW-SMR filter, IEEE Eur. Microwave Conf., pp. 905-908, 2006).

En revanche, ces filtres, comme les filtres SAW à couplage électrique ne peuvent être que totalement asymétriques ou différentiels. Par ailleurs, ils ne permettent pas de réaliser de transformation d'impédance. Lorsque ces conversions sont requises pour l'architecture RF, il est donc nécessaire d'ajouter des composants de type « BalUn » (pour Balanced/Unbalanced) qui sont volumineux et qui augmentent les pertes.

Considérons maintenant les filtres à couplage acoustique de type SCF (pour Stacked Crystal Filter) et de type CRF (pour Coupled Resonator Filter) qui sont exploités dans les filtres BAW.

On présente ci-après ces composants de manière succincte.

Les premiers travaux concernant les filtres à couplage acoustique en mode d'épaisseur sont dus à A. Ballato et T. Lukaszek en 1972 et 1973. Leur dispositif, qui consistait à coller deux résonateurs à quartz r1 et r2 (voir la figure 17A où les références 108 et 109 désignent des électrodes, la référence 110 un plan de masse et les références 112 et 114 des couches piézoélectriques) a été repris en 1987, en profitant des techniques de la microélectronique pour résoudre les problèmes de collage (voir G.R. Kline et al., Low insertion loss filters synthetized with thin film resonators, IEEE Ultrason. Symp., 1987).

La technologie SAW DMS permet de combiner à la fois la fonction de filtrage et les fonctions de conversion de mode et d'impédance. Cet avantage, couplé aux progrès de la technologie SAW en termes d'encapsulation et de tenue en puissance, fait aujourd'hui de ces filtres des composants incontournables sur le marché des filtres radiofréquences. Pour s'imposer, la technologie BAW, qui nécessite plus d'étapes de fabrication, doit offrir également ces propriétés de conversion de mode et de transformation d'impédance.

Un composant a été proposé (voir US 6 720 844) pour répondre à ces besoins (voir la figure 17B). Il est fondé sur le concept du SCF (pour Stacked Crystal Filtre) ; une ou des couches de couplage isolantes 116 sont intercalées entre les deux résonateurs r1 et r2. Ceci a pour avantage, d'une part, d'élargir la bande passante du filtre et, d'autre part, d'isoler électriquement l'entrée électrique de la sortie. Ce composant est noté CRF (pour Coupled Resonator Filter).

Ce composant permet d'obtenir des filtres plus compacts et plus complets (voir US 2005/0206476**,** US 6 917 261 et WO 2005/046052). En revanche, au contraire des filtres SAW à couplage acoustique, où le couplage de l'onde se fait dans le plan du substrat, la fabrication d'un filtre CRF se révèle complexe car elle nécessite l'empilement de deux résonateurs BAW.

Par ailleurs, l'une des conditions incontournables pour le bon fonctionnement de ce filtre est l'ajustement, à quelques MHz près, des fréquences de résonance des deux résonateurs. Ceci peut expliquer que, malgré la littérature très abondante dans le domaine des résonateurs et filtres BAW, seules deux réalisations fonctionnelles de filtres CRF ont été présentées à ce jour (voir K.M. Lakin, Coupled Resonator Filter, IEEE Ultrason. Symp., pp. 901-908, 2002, et G.G. Fattinger et al., Coupled bulk acoustic wave resonator filters : Key technology for single-to-balanced RF filters, IEEE MTT-S Digest, pp. 927-929, 2004).

On rappelle que dans un résonateur conforme à l'invention, l'intensité du champ électrique engendré par l'électret est déterminée pour décaler la fréquence de résonance du résonateur d'une valeur souhaitée. Et l'on précise que cet électret est un électret en matériau minéral, par exemple $SiO_2$, SiN, $Al_2O_3$, ou $SrTiO_3$ : un électret en matériau minéral présente l'avantage d'être beaucoup plus rigide qu'un électret en matériau polymère.

## Revendications

**1.** Résonateur acoustique, comprenant :

- au moins une couche piézoélectrique (22 ; 30 ; 34, 36),
- des première et deuxième électrodes (24, 26) de part et d'autre de la couche piézoélectrique, et
- au moins une couche d' électret (22, 32) entre les première et deuxième électrodes,

**caractérisé en ce que** la couche d' électret est prévue pour appliquer un champ électrique permanent à la couche piézoélectrique, dont l'intensité est telle que ce champ électrique décale la fréquence de résonance du résonateur d'une valeur souhaitée, et **en ce que** la couche d' électret est faite d'un matériau minéral.

**2.** Résonateur acoustique selon la revendication 1, dans lequel, la ou les couches piézoélectriques présentant respectivement des propriétés électromécaniques, ladite couche d' électret (22, 32) comporte des charges électriques permanentes, permettant de modifier lesdites propriétés électromécaniques.

3. Résonateur acoustique selon l'une quelconque des revendications 1 et 2, dans lequel la couche d'électret (22, 32) est en matériau piézoélectrique.

4. Résonateur acoustique selon l'une quelconque des revendications 1 à 3, dans lequel l'épaisseur de la couche d'électret (22, 32) est choisie de quelques nanomètres à quelques dizaines de micromètres, et de préférence elle est inférieure ou égale à environ 1 $\mu$m.

5. Résonateur acoustique selon l'une quelconque des revendications 1 à 4, dans lequel la couche piézoélectrique (22) contient des charges électriques pour constituer elle-même la couche d' électret, de sorte que la couche piézoélectrique et la couche d'électret constituent alors une seule et même couche.

6. Résonateur acoustique selon l'une quelconque des revendications 1 à 4, dans lequel la couche d'électret (32) est distincte de la ou les couches piézoélectriques.

7. Résonateur acoustique selon la revendication 6, dans lequel la couche d'électret (32) est comprise entre la couche piézoélectrique (30) et l'une des première et deuxième électrodes (24, 26).

8. Résonateur acoustique selon la revendication 6, comprenant des première et deuxième couches piézoélectriques (34, 36) et dans lequel la couche d' électret (32) est comprise entre les première et deuxième couches piézoélectriques.

9. Résonateur acoustique selon l'une quelconque des revendications 5 à 8, comportant en outre un substrat sur une face duquel est disposée l'une des électrodes (24, 26), dans lequel le substrat est pourvu d'une cavité (54), ou trou, qui débouche au moins sur une face du substrat, et dans lequel l'une des première et deuxième électrodes repose sur cette face du substrat, au-dessus de la cavité.

10. Résonateur acoustique selon l'une quelconque des revendications 5 à 8, comportant en outre un substrat sur une face duquel est disposée l'une des électrodes (24, 26), ce résonateur acoustique comprenant en outre un réseau de Bragg acoustique (70, 72, 74, 76) disposé entre le substrat et l'une des première et deuxième électrodes.

11. Résonateur acoustique selon l'une quelconque des revendications 1 à 10, dans lequel la couche d'électret est cristalline.

12. Résonateur acoustique selon l'une quelconque des revendications 1 à 10, dans lequel la couche d'électret est amorphe.

13. Filtre commutable à résonateurs couplés, comprenant des résonateurs acoustiques (78, 80) qui sont couplés acoustiquement les uns aux autres et dans lequel l'un (80) au moins des résonateurs acoustiques est conforme à l'une quelconque des revendications 1 à 12.

14. Procédé de fabrication d'un résonateur acoustique, comprenant :

- la formation d'au moins une couche piézoélectrique (46 ; 66, 68),
- la formation de première et deuxième électrodes (44, 52) de part et d'autre de la couche piézoélectrique, et
- la formation d'au moins une couche d' électret faite d'un matériau minéral (46, 62, 64) entre les première et deuxième électrodes, pour appliquer un champ électrique continu et permanent à la couche piézoélectrique,

dans lequel l'intensité de ce champ électrique est déterminée pour décaler la fréquence de résonance du résonateur d'une valeur souhaitée.

15. Procédé selon la revendication 14, comprenant, à partir d'un substrat (36) pourvu de la première électrode (44) et d'une couche sacrificielle (40) au niveau d'une face du substrat, la première électrode reposant sur cette face du substrat, au-dessus de la couche sacrificielle :

- la formation d'une structure sur la première électrode, la structure étant choisie parmi :

  • une couche apte à constituer à la fois la couche piézoélectrique et la couche d'électret, de sorte que la couche piézoélectrique et la couche d'électret constituent alors une seule et même couche,

• un ensemble comprenant la couche piézoélectrique et une couche apte à constituer la couche d'électret, et
• un ensemble comprenant des première et deuxième couches piézoélectriques et une couche apte à constituer la couche d' électret, entre les première et deuxième couches piézoélectriques,

- la formation de la deuxième électrode (52),
- le chargement électrique permanent de la couche apte à constituer la couche d'électret, et
- l'élimination de tout ou partie de la couche sacrificielle.

**16.** Procédé selon la revendication 14, comprenant :

- la formation d'un réseau de Bragg acoustique (70, 72, 74, 76) sur un substrat (36),
- la formation de la première électrode (44) sur le réseau de Bragg acoustique,
- la formation d'une structure sur la première électrode, la structure étant choisie parmi :

• une couche apte à constituer à la fois la couche piézoélectrique et la couche d'électret, de sorte que la couche piézoélectrique et la couche d'électret constituent alors une seule et même couche,
• un ensemble comprenant la couche piézoélectrique et une couche apte à constituer la couche d'électret, et
• un ensemble comprenant des première et deuxième couches piézoélectriques et une couche apte à constituer la couche d'électret, entre les première et deuxième couches piézoélectriques,

- la formation de la deuxième électrode (52), et
- le chargement électrique permanent de la couche apte à constituer la couche d'électret.

**17.** Procédé selon l'une quelconque des revendications 15 et 16, dans lequel le chargement électrique permanent de la couche apte à constituer la couche d'électret est effectué par une méthode choisie parmi l'implantation ionique et/ou l'implantation électronique.

**18.** Procédé selon l'une quelconque des revendications 15 et 16, dans lequel le chargement électrique permanent de la couche apte à constituer la couche d'électret est effectué par une méthode choisie parmi l'implantation ionique et/ou l'implantation électronique et/ou la décharge Corona et/ou la méthode de l'électrode humide, et dans lequel le chargement électrique permanent est effectué avant la formation de la deuxième électrode.

**19.** Procédé selon l'une quelconque des revendications 15 à 18, dans lequel, pour une ou des couches piézoélectriques formant un empilement présentant une fréquence de résonance, les charges électriques permanentes, introduites dans la couche apte à constituer la couche d'électret, sont telles qu'elles permettent d'obtenir un décalage déterminé ou choisi, de la fréquence de résonance de l' empilement, ce qui permet d'ajuster la fréquence du résonateur.

**Patentansprüche**

**1.** Akustischer Resonator, umfassend:

- wenigstens eine piezoelektrische Schicht (22; 30; 34, 36),
- eine erste und eine zweite Elektrode (24, 26) auf der einen und der anderen Seite der piezoelektrischen Schicht und
- wenigstens eine Elektretschicht (22, 32) zwischen der ersten und der zweiten Elektrode,

**dadurch gekennzeichnet, dass** die Elektretschicht dazu vorgesehen ist, ein permanentes elektrisches Feld an die piezoelektrische Schicht anzulegen, dessen Intensität derart ist, dass das elektrische Feld die Resonanzfrequenz des Resonators um einen gewünschten Wert verschiebt und dadurch, dass die Elektretschicht aus einem mineralischen Material hergestellt ist.

**2.** Akustischer Resonator nach Anspruch 1, wobei die piezoelektrische Schicht oder die piezoelektrischen Schichten jeweils elektromechanische Eigenschaften aufweist/aufweisen, wobei die Elektretschicht (22, 32) permanente elektrische Ladungen enthält, die es ermöglichen, die elektromechanischen Eigenschaften zu modifizieren.

**3.** Akustischer Resonator nach einem der Ansprüche 1 und 2, wobei die Elektretschicht (22, 32) aus einem piezoelektrischen Material besteht.

4. Akustischer Resonator nach einem der Ansprüche 1 bis 3, wobei die Dicke der Elektretschicht (22, 32) von einigen Nanometern bis zu einigen zehn Mikrometern ausgewählt ist, und sie bevorzugt kleiner oder gleich etwa 1 μm ist.

5. Akustischer Resonator nach einem der Ansprüche 1 bis 4, wobei die piezoelektrische Schicht (22) elektrische Ladungen enthält, um selbst die Elektretschicht zu bilden, so dass die piezoelektrische Schicht und die Elektretschicht also ein und dieselbe Schicht bilden.

6. Akustischer Resonator nach einem der Ansprüche 1 bis 4, wobei die Elektretschicht (32) von der piezoelektrischen Schicht oder den piezoelektrischen Schichten verschieden ist.

7. Akustischer Resonator nach Anspruch 6, wobei die Elektretschicht (32) zwischen der piezoelektrischen Schicht (30) und einer von der ersten und der zweiten Elektrode (24, 26) liegt.

8. Akustischer Resonator nach Anspruch 6, umfassend eine erste und eine zweite piezoelektrische Schicht (34, 36), und wobei die Elektretschicht (32) zwischen der ersten und der zweiten piezoelektrischen Schicht liegt.

9. Akustischer Resonator nach einem der Ansprüche 5 bis 8, weiterhin umfassend ein Substrat, auf dessen einer Seite die eine der Elektroden (24, 26) angeordnet ist, wobei das Substrat mit einer Ausnehmung (54) oder einem Loch ausgestattet ist, welche/welches wenigstens auf einer Seite des Substrats herauskommt, und wobei die eine der ersten und zweiten Elektrode auf dieser Seite des Substrats oberhalb von der Ausnehmung ruht.

10. Akustischer Resonator nach einem der Ansprüche 5 bis 8, weiterhin umfassend ein Substrat, auf dessen einer Seite die eine der Elektroden (24, 26) angeordnet ist, wobei der akustische Resonator weiterhin ein akustisches Bragg-Gitter (70, 72, 74, 76) umfasst, welches zwischen dem Substrat und der einen von der ersten und der zweiten Elektrode angeordnet ist.

11. Akustischer Resonator nach einem der Ansprüche 1 bis 10, wobei die Elektretschicht kristallin ist.

12. Akustischer Resonator nach einem der Ansprüche 1 bis 10, wobei die Elektretschicht amorph ist.

13. Schaltbarer Filter mit gekoppelten Resonatoren, umfassend akustische Resonatoren (78, 80), die miteinander akustisch gekoppelt sind, und wobei wenigstens einer (80) der akustischen Resonatoren ein Resonator nach einem der Ansprüche 1 bis 12 ist.

14. Verfahren zur Herstellung eines akustischen Resonators, umfassend:

- die Bildung von wenigstens einer piezoelektrischen Schicht (46; 66, 68),
- die Bildung einer ersten und einer zweiten Elektrode (44, 52) auf der einen und der anderen Seite der piezoelektrischen Schicht, und
- die Bildung von wenigstens einer Elektretschicht, die aus einem mineralischen Material hergestellt ist (46, 62, 64), zwischen der ersten und der zweiten Elektrode, um ein kontinuierliches und permanentes elektrisches Feld an die piezoelektrische Schicht anzulegen,

wobei die Intensität dieses elektrischen Feldes bestimmt ist, um die Resonanzfrequenz des Resonators um einen gewünschten Wert zu verschieben.

15. Verfahren nach Anspruch 14, umfassend, ausgehend von einem Substrat (36), welches mit der ersten Elektrode (44) und einer Opferschicht (40) auf Höhe einer Seite des Substrats ausgestattet ist, wobei die erste Elektrode auf dieser Seite des Substrats oberhalb der Opferschicht ruht:

- die Bildung einer Struktur auf der ersten Elektrode, wobei die Struktur ausgewählt ist aus:

  • einer Schicht, die dazu geeignet ist, gleichzeitig die piezoelektrische Schicht und die Elektretschicht zu bilden, so dass die piezoelektrische Schicht und die Elektretschicht also ein und dieselbe Schicht bilden,
  • einer Anordnung, welche die piezoelektrische Schicht und eine Schicht umfasst, die dazu geeignet ist, die Elektretschicht zu bilden, und
  • einer Anordnung, welche eine erste und eine zweite piezoelektrische Schicht umfasst, sowie eine Schicht, die dazu geeignet ist, die Elektretschicht zu bilden, zwischen der ersten und der zweiten piezoelektrischen Schicht,

- die Bildung der zweiten Elektrode (52),
- die permanente elektrische Aufladung der Schicht, die dazu geeignet ist, die Elektretschicht zu bilden, und
- die vollständige oder teilweise Eliminierung der Opferschicht.

**16.** Verfahren nach Anspruch 14, umfassend:

- die Bildung eines akustischen Bragg-Gitters (70, 72, 74, 76) auf einem Substrat (36),
- die Bildung der ersten Elektrode (44) auf dem akustischen Bragg-Gitter,
- die Bildung einer Struktur auf der ersten Elektrode, wobei die Struktur ausgewählt ist aus:

  • einer Schicht, die dazu geeignet ist, gleichzeitig die piezoelektrische Schicht und die Elektretschicht zu bilden, so dass die piezoelektrische Schicht und die Elektretschicht also ein und dieselbe Schicht bilden,
  • einer Anordnung, welche die piezoelektrische Schicht und eine Schicht umfasst, die dazu geeignet ist, die Elektretschicht zu bilden, und
  • einer Anordnung, welche eine erste und eine zweite piezoelektrische Schicht umfasst, und eine Schicht, die dazu geeignet ist, die Elektretschicht zu bilden, zwischen der ersten und der zweiten piezoelektrischen Schicht,

- die Bildung der zweiten Elektrode (52) und
- die permanente elektrische Aufladung der Schicht, die dazu geeignet ist, die Elektretschicht zu bilden.

**17.** Verfahren nach einem der Ansprüche 15 und 16, wobei die permanente elektrische Aufladung der Schicht, die dazu geeignet ist, die Elektretschicht zu bilden, durch ein Verfahren durchgeführt wird, das ausgewählt ist aus der Ionen-Implantation oder/und der Elektronen-Implantation.

**18.** Verfahren nach einem der Ansprüche 15 und 16, wobei die permanente elektrische Aufladung der Schicht, die dazu geeignet ist, die Elektretschicht zu bilden, durch ein Verfahren ausgeführt wird, das ausgewählt ist aus der Ionen-Implantation oder/und der Elektronen-Implantation oder/und der Korona-Entladung oder/und dem Verfahren der feuchten Elektrode, und wobei die permanente elektrische Aufladung vor der Bildung der zweiten Elektrode durchgeführt wird.

**19.** Verfahren nach einem der Ansprüche 15 bis 18, wobei für eine piezoelektrische Schicht oder für piezoelektrische Schichten, die einen Stapel bildet/bilden, welcher eine Resonanzfrequenz aufweist, die permanenten elektrischen Ladungen, die in die Schicht eingeführt werden, die dazu geeignet ist, die Elektretschicht zu bilden, derart sind, dass sie es ermöglichen, eine bestimmte oder ausgewählte Verschiebung der Resonanzfrequenz des Stapels zu erhalten, was es ermöglicht, die Frequenz des Resonators einzustellen.

## Claims

**1.** Acoustic resonator, comprising:

- at least one piezoelectric layer (22; 30; 34, 36),
- first and second electrodes (24, 26) on either side of the piezoelectric layer, and
- at least one electret layer (22, 32) between the first and second electrodes,

**characterised in that** the electret layer is provided to apply a permanent electric field to the piezoelectric layer, the intensity of which is such that this electric field shifts the resonance frequency of the resonator by a desired value, and **in that** the electret layer is made of a mineral material.

**2.** Acoustic resonator according to claim 1, wherein, the piezoelectric layer or layers having respectively electromechanical properties, said electret layer (22, 32) comprises permanent electrical charges, making it possible to modify said electromechanical properties.

**3.** Acoustic resonator according to any one of claims 1 and 2, wherein the electret layer (22, 32) is made of piezoelectric material.

4. Acoustic resonator according to any one of claims 1 to 3, wherein the thickness of the electret layer (22, 32) is chosen from a few nanometres to a few tens of micrometres, and preferably it is less than or equal to around 1 μm.

5. Acoustic resonator according to any one of claims 1 to 4, wherein the piezoelectric layer (22) contains electrical charges to constitute itself the electret layer, so that the piezoelectric layer and the electret layer then constitute a single layer.

6. Acoustic resonator according to any of claims 1 to 4, wherein the electret layer (32) is separate from the piezoelectric layer or layers.

7. Acoustic resonator according to claim 6, wherein the electret layer (32) lies between the piezoelectric layer (30) and one of the first and second electrodes (24, 26).

8. Acoustic resonator according to claim 6, comprising first and second piezoelectric layers (34, 36) and wherein the electret layer (32) lies between the first and second piezoelectric layers.

9. Acoustic resonator according to any one of claims 5 to 8, further comprising a substrate on one face of which is arranged one of the electrodes (24, 26), wherein the substrate is provided with a cavity (54), or hole, which opens up onto at least one face of the substrate, and wherein one of the first and second electrodes lies on this face of the substrate, above the cavity.

10. Acoustic resonator according to any one of claims 5 to 8, further comprising a substrate on one face of which is arranged one of the electrodes (24, 26), this acoustic resonator further comprising an acoustic Bragg grating (70, 72, 74, 76) arranged between the substrate and one of the first and second electrodes.

11. Acoustic resonator according to any one of claims 1 to 10, wherein the electret layer is crystalline.

12. Acoustic resonator according to any one of claims 1 to 10, wherein the electret layer is amorphous.

13. Switchable coupled resonator filter, comprising acoustic resonators (78, 80) which are acoustically coupled to each other and wherein one (80) at least of the acoustic resonators conforms to any one of claims 1 to 12.

14. Method of producing an acoustic resonator, comprising:

- the formation of at least one piezoelectric layer (46; 66, 68),
- the formation of first and second electrodes (44, 52) on either side of the piezoelectric layer, and
- the formation of at least one electret layer (46, 62, 64) between the first and second electrodes, to apply a continuous and permanent electric field to the piezoelectric layer,

wherein the intensity of this electric field is determined to shift the resonance frequency of the resonator by a desired value.

15. Method according to claim 14, comprising, beginning with a substrate (36) provided with the first electrode (44) and a sacrificial layer (40) at one face of the substrate, the first electrode lying on this face of the substrate, above the sacrificial layer:

- the formation of a structure on the first electrode, the structure being chosen from:

  • a layer suited to constituting both the piezoelectric layer and the electret layer, so that the piezoelectric layer and the electret layer then constitute a single layer,
  • a set comprising the piezoelectric layer and a layer suited to constituting the electret layer, and
  • a set comprising first and second piezoelectric layers and a layer suited to constituting the electret layer, between the first and second piezoelectric layers,

- the formation of the second electrode (52),
- the permanent electrical charging of the layer suited to constituting the electret layer, and
- the elimination of all or part of the sacrificial layer.

**16.** Method according to claim 14, comprising:

- the formation of an acoustic Bragg grating (70, 72, 74, 76) on a substrate (36),
- the formation of the first electrode (44) on the acoustic Bragg grating,
- the formation of a structure on the first electrode, the structure being chosen from:

  • a layer suited to constituting both the piezoelectric layer and the electret layer, so that the piezoelectric layer and the electret layer then constitute a single layer,
  • a set comprising the piezoelectric layer and a layer suited to constituting the electret layer, and
  • a set comprising first and second piezoelectric layers and a layer suited to constituting the electret layer, between the first and second piezoelectric layers,

- the formation of the second electrode (52), and
- the permanent electrical charging of the layer suited to constituting the electret layer.

**17.** Method according to any one of claims 15 and 16, wherein the permanent electrical charging of the layer suited to constituting the electret layer is carried out by a method chosen from ion implantation and/or electron implantation.

**18.** Method according to any one of claims 15 and 16, wherein the permanent electrical charging of the layer suited to constituting the electret layer is carried out by a method chosen from ion implantation and/or electron implantation and/or Corona discharge and/or the damp electrode method, and wherein the permanent electrical charging is carried out before the formation of the second electrode.

**19.** Method according to any one of claims 15 to 18, wherein, for a piezoelectric layer or layers forming a stack having a resonance frequency, the permanent electrical charges, introduced into the layer suited to constituting the electret layer, are such that they make it possible to obtain a determined or chosen shift, of the resonance frequency of the stack, which makes it possible to tune the frequency of the resonator.

6
4
2

FIG. 1

12
14
8
10
16
20
18

FIG. 2

28
26
22
24

FIG. 3

28
26
32
30
24

FIG. 4A

26
28
30
32
24

FIG. 4B

26
28
36
32
34
24

FIG. 5

38
40
A
A

FIG. 6A

38
40
36

FIG. 6B

A
A
45
44

FIG. 6C

45
38
40
44
42
36

FIG. 6D

48
44
46
50
A
A
48
44

FIG. 6E

46
44
42
38
40
36

FIG. 6F

44
52
A
A
44

FIG. 6G

52
46
44
42
38
40
36

FIG. 6H

44
52
A
A
44

FIG. 6I

52
46
44
42
38
36
54

FIG. 6J

44
52
56
44

FIG. 6K

58
59
52
46
44
42
38
36
54

FIG. 6L

38
40
A
A

FIG. 7A

38
40
36

FIG. 7B

A
A
45
44

FIG. 7C

45
40
44
42
38
36

FIG. 7D

48
44
46
50
A
A
48
44

FIG. 7E

46
44
42
38
40
36

FIG. 7F

60
61
46
44
42
38
40
36

FIG. 7G

52
61
46
44
42
38
36
54

FIG. 7H

44
52
A
A
44

FIG. 8A

52
62
46
44
42
38
36
54

FIG. 8B

52
68
64
66
44
42
38
36
54

FIG. 9

44
52
A
A
44

FIG. 10A

52
62
46
44
42
76
74
72
70
36

FIG. 10B

Ve
94
96
90
80
92
82
88
78
84
Vs
86

FIG. 11

98
100
102
104
106

FIG. 12

98
100
102
104
106

FIG. 13

98
100
102
104
106

FIG. 14

FIG. 15A

FIG. 15B

R1
R2
$V_{in}$
$V_{out}$
$S_{12}$ (dB)
0
-5
-10
-15
-20
f
I
II
III
IV
IV

FIG. 16A

FIG. 16B

108
110
112
r1
r2
109
114

FIG. 17A

116
r1
r2

FIG. 17B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 20070063793 A
- US 2486560 A
- US 4057660 A
- DE 1245441
- US 3118022 A
- EP 0608162 A
- US 6928178 A
- FR 2905207
- US 2008129416 A
- US 6720844 B
- US 20050206476 A
- US 6917261 B
- WO 2005046052 A


### Littérature non-brevet citée dans la description


- **ROMAN LANZ.** Piezoelectric Thin Films for Bulk Acoustic Wave Resonator Applications : From Processing to Microwave Filters. l'Ecole Polytechnique Fédérale de Lausanne, 2004
- **LEONOV et al.** *IEEE Transactions on dielectrics and electrical insulation,* 01 Octobre 2006, vol. 13 (5), 1049-1056
- **GUNTHER et al.** Sensors and actuators A. Elsevier Sequoia S.A, 01 Avril 1992, vol. 32, 357-360
- **WEI PANG et al.** Journal of microelectromechanical systems. IEEE, 01 Décembre 2007, vol. 16, 1303-1313
- **J.A. GIACOMETTI et al.** Corona Charging of Polymers. *IEEE Transactions on Electrical Insulation,* Octobre 1992, vol. 27 (5
- **FABIO PEANO et al.** Design and optimisation of a MEMS electret-based capacitive energy scavenger. *J. of Electromechanical systems,* 2005, vol. 14 (3
- **P. GUNTHER.** Charging, Long-term Stability, and TSD measurements of SiO2 electrets. *IEEE Transactions on electrical insulation,* Juin 1989, vol. 24 (3
- **V. LEONOV et al.** Stabilization of Positive Charge in SiO2/Si3N4 Electrets, IMEC. *IEEE Transactions on Dielectrics and Electrical Insulation,* Octobre 2006, vol. 13 (5
- **A. VOLATIER et al.** Design, elaboration and characterization of coupled resonator filters for WCDMA applications. *Ultrasonic symposium,* 2006, 829-832
- **A. VOLATIER et al.** Switchable and tunable strontium titanate electrostrictive bulk acoustic wave resonator integrated with a Bragg mirror. *Applied Physics Letters,* 2008, vol. 92 (3), 032906-032909
- **K. IKEZAKI et al.** Thermally Stimulated Currents from Ion-Injected Teflon-FEP Film Electrets. *Jpn. J. Appl. Phys.,* 1981, vol. 20, 1741-1747
- **M. BRUEL.** Silicon on insulator material technology. *Electronic letters,* 1995, vol. 31 (14), 1201-1202
- **L. DICIOCCIO et al.** Silicon carbide on insulator formation by Smart Cut™ process. *Master, Sci. Eng.,* 1997, vol. B46, 349-356
- **E. JALAGUIER et al.** Transfer on thin GaAs film on silicon substrate by proton implantation process. *Electronic letters,* 1998, vol. 34 (4), 408-409
- **E. JALAGUIER et al.** Transfer of thin InP film onto silicon substrate by proton implantation process. *IEEE Proc.11th International Conference on Indium Phosphide and Related Materials,* 1999
- **A. TAUZIN et al.** Transfers of 2- inch GaN films onto sapphire substrates using Smart CutTM technology. *Electronics Letters,* 2005, vol. 41 (11
- **C. DEGUET et al.** 200 mm Germanium-On-Insulator (GeOI) structures realized from epitaxial Germanium wafers by the Smart Cut™ technology. Electro Chemical Society, 2005
- **W.E. NEWELL.** Face-mounted piezoelectric resonators. *Proc. of IEEE,* 1965, 575-581
- **K.M. LAKIN et al.** Development of miniature filters for wireless applications. *IEEE Trans. Microwave Theory. Tech.,* 1995, vol. 43 (12), 2933-2939
- **K.M. LAKIN.** Fundamental properties of thin film resonators. *IEEE Freq. Contr. Symp.,* 1991, 201-206
- **M.A. DUBOIS.** Aluminium nitride and lead zirconate-titanate thin films for ultrasonics applications : integration, properties and devices. *Thèse de l'EPFL,* 1999
- **A. SHIRAKAWA et al.** A high isolation and high selectivity Ladder-Lattice BAW BAW-SMR filter. *IEEE Eur. Microwave Conf.,* 2006, 905-908
- **G.R. KLINE et al.** Low insertion loss filters synthetized with thin film resonators. *IEEE Ultrason. Symp.,* 1987

- **K.M. LAKIN.** Coupled Resonator Filter. *IEEE Ultrason. Symp.,* 2002, 901-908
- **G.G. FATTINGER et al.** Coupled bulk acoustic wave resonator filters : Key technology for single-to-balanced RF filters. *IEEE MTT-S Digest,* 2004, 927-929